# EUROPEAN PATENT APPLICATION

(11) **EP 4 414 970 A1**
(43) Date of publication of application: **14.08.2024**
(21) Application number: 22948425.8
(22) Date of filing: 29.06.2022
(51) Int. Cl.: G09F 9/00

(54) **TRANSPARENT DISPLAY PANEL AND DISPLAY APPARATUS**

(71) Applicant: Boe Technology Group Co., Ltd., Beijing 100015 (CN)
(72) Inventor: LIU, Dongni, Beijing 100176 (CN); XUAN, Minghua, Beijing 100176 (CN); ZHANG, Zhenyu, Beijing 100176 (CN); ZHENG, Haoliang, Beijing 100176 (CN); ZHANG, Shunhang, Beijing 100176 (CN); CHEN, Wanzhi, Beijing 100176 (CN); QI, Qi, Beijing 100176 (CN); LIU, Jing, Beijing 100176 (CN)
(74) Representative: Durán-Corretjer, S.L.P.
(86) International application number: PCT/CN2022/102500
(87) International publication number: WO 2024/000310

(57) **Abstract**

A transparent display panel (910), comprising: a substrate (100), and multiple repeating units (10) arranged in an array on the substrate (100). A non-light transmitting zone (A1) of the repeating units (10) comprises: at least one pixel unit (P), N groups of first wirings (11) that are electrically connected to the pixel units (P) and extend along a first direction (X), and M groups of second wirings (12) that extend along a second direction (Y). A group of first wirings (11) comprises multiple first signal lines (111) and at least one second signal line (112), the orthographic projection of the at least one second signal line (112) on the substrate (100) covering the orthographic projections of at least two first signal lines (111) on the substrate (100); alternatively, a group of second wirings (12) comprises multiple third signal lines (121) and at least one fourth signal line (122), the orthographic projection of the at least one fourth signal line (122) on the substrate (100) covering the orthographic projections of at least two third signal lines (121) on the substrate (100).

## Description

### Technical Field

The present disclosure relates to, but is not limited to, the field of display technology, in particular to a transparent display panel and a display apparatus.

### Background

Transparent display technology has a broad application prospect as it can present not only images in the display but also physical objects behind the display. The transparent display technology has been widely applied in display windows, transparent TV, vehicle-mounted technology, virtual reality (VR), augmented reality (AR) and other fields.

### Summary

The following is a summary of subject matters described herein in detail. The summary is not intended to limit the protection scope of claims.

An embodiment of the present disclosure provides a transparent display panel and a display apparatus.

In one aspect, an embodiment of the present disclosure provides a transparent display panel including a substrate and a plurality of repeating units arranged in an array on the substrate. A repeating unit includes a non-transmissive region and a plurality of transmissive sub-regions, and adjacent transmissive sub-regions are spaced apart by a non-transmissive region. Said non-transmissive region includes at least one pixel unit and N sets of first traces extending in a first direction and M sets of second traces extending in a second direction electrically connected to said at least one pixel unit. Said first direction intersects said second direction, N and M are both positive integers, and N and M are not both greater than 1. At least one set of first traces includes a plurality of first signal lines and at least one second signal line, and an orthographic projection of said at least one second signal line on said substrate covers an orthographic projection of at least two first signal lines on said substrate; or, at least one set of second traces include a plurality of third signal lines and at least one fourth signal line, and an orthographic projection of said at least one fourth signal line on said substrate covers an orthographic projection of at least two third signal lines on said substrate.

In some exemplary embodiments, a size of said at least one second signal line in said second direction is larger than a size of said at least two first signal lines in said second direction.

In some exemplary embodiments, said at least one second signal line is located on a side of said at least two first signal lines away from said substrate.

In some exemplary embodiments, a size of said at least one fourth signal line in said first direction is larger than a size of said at least two third signal lines in said first direction.

In some exemplary embodiments, said at least one fourth signal line is located on a side of said at least two third signal lines away from said substrate.

In some exemplary embodiments, said at least one second signal line or said at least one fourth signal line is a power supply line.

In some exemplary embodiments, both N and M are 1.

In some exemplary embodiments, a set of first traces includes a plurality of first signal lines, and a set of second traces includes a plurality of third signal lines and at least one fourth signal line. Said at least one fourth signal line includes a first power supply line and a second power supply line; an orthographic projection of at least one of said first power supply line and said second power supply line on said substrate covers an orthographic projection of said plurality of third signal lines on said substrate.

In some exemplary implementations, a plurality of first signal lines of a set of first traces include a scan line, a light emitting control line, a first power connection line, and a second power connection line; said first power connection line is electrically connected to said first power supply line, and said second power connection line is electrically connected to said second power supply line.

In some exemplary implementations, the transparent display panel further includes a shift-scan circuit; an orthographic projection of said at least one fourth signal line on said substrate overlaps with said shift-scan circuit.

In some exemplary embodiments, said non-transmissive region of said repeating unit includes three pixel units arranged sequentially in said first direction, the set of second traces are adjacent to a second pixel unit.

In some exemplary embodiments, a set of first traces include a plurality of first signal lines and at least one second signal line, and a set of second traces includes a plurality of third signal lines. Said at least one second signal line includes a first power supply line and a second power supply line; an orthographic projection of at least one of said first power supply line and said second power supply line on said substrate covers an orthographic projection of at least two first signal lines on said substrate.

In some exemplary implementations, said plurality of first signal lines includes at least one scan line and at least one light emitting control line that are electrically connected to said at least one pixel unit.

In some exemplary embodiments, said plurality of third signal lines includes at least a plurality of data lines electrically connected to said at least one pixel unit.

In some exemplary implementations, an orthographic projection of said second power supply line on said substrate overlaps with an orthographic projection of said at least one pixel unit on said substrate, and said first power supply line is located on a side of said second power supply line away from said pixel unit.

In some exemplary embodiments, said at least one pixel unit includes a plurality of sub-pixels emitting different colors, each sub-pixel includes a light emitting element and a pixel circuit electrically connected to said light emitting element, a first electrode of said light emitting element is electrically connected to said pixel circuit via an anode pad, a second electrode of said light emitting element is electrically connected to a cathode pad, and said cathode pad and said second power supply line are an integrated structure.

In some exemplary implementations, a first voltage signal provided by said first power supply line is greater than a second voltage signal provided by the second power supply line.

In some exemplary embodiments, said repeating unit is a quadrilateral.

In some exemplary implementations, said non-transmissive region includes two pixel units, a set of first traces and two sets of second traces, and said two pixel units are arranged in said first direction and are misaligned.

In some exemplary embodiments, a set of first traces include a plurality of first signal lines, a first signal line includes a first line segment extending in a first direction and a second line segment extending in a second direction that are connected sequentially, each of two sets of second traces includes a plurality of third traces and at least one fourth trace, and an orthographic projection of the at least one fourth trace on the substrate overlaps with an orthographic projection of second line segments of the plurality of first signal lines on the substrate.

In some exemplary embodiments, said at least one pixel unit includes a plurality of sub-pixels emitting different colors, each sub-pixel includes a light emitting element and a pixel circuit electrically connected to said light emitting element, and an orthographic projection of the light emitting element of said sub-pixel on said substrate overlaps with an orthographic projection of the electrically connected pixel circuit on said substrate.

In another aspect, an embodiment of the present disclosure provides a display apparatus, which includes the aforementioned transparent display panel.

Other aspects may be understood upon reading and understanding the drawings and detailed description.

### Brief Description of Drawings

Accompanying drawings are used for providing further understanding of technical solutions of the present disclosure, constitute a part of the specification, and together with the embodiments of the present disclosure, are used for explaining the technical solutions of the present disclosure but not to constitute limitations on the technical solutions of the present disclosure. Shapes and sizes of one or more components in the drawings do not reflect true scales, and are only intended to schematically describe contents of the present disclosure.
FIG. 1 is an equivalent circuit diagram of a pixel circuit according to at least one embodiment of the present disclosure.
FIG. 2 is an operating timing diagram of the pixel circuit shown in FIG. 1.
FIG. 3 is a partial schematic view of a transparent display panel according to at least one embodiment of the present disclosure.
FIG. 4 is a schematic diagram of a repeating unit of a transparent display panel according to at least one embodiment of the present disclosure.
FIG. 5 is a schematic partial sectional view of a transparent display panel according to at least one embodiment of the present disclosure.
FIG. 6A is a schematic diagram of a semiconductor layer of a repeating unit according to at least one embodiment of the present disclosure.
FIG. 6B is a schematic view of a first conductive layer of a repeating unit according to at least one embodiment of the present disclosure.
FIG. 6C is a schematic view of a second conductive layer of a repeating unit according to at least one embodiment of the present disclosure.
FIG. 6D is a schematic view of a third insulating layer of a repeating unit according to at least one embodiment of the present disclosure.
FIG. 6E is a schematic diagram of a third conductive layer of a repeating unit according to at least one embodiment of the present disclosure.
FIG. 6F is a schematic diagram of a fifth insulating layer of a repeating unit according to at least one embodiment of the present disclosure.
FIG. 6G is a schematic view of a fourth conductive layer of a repeating unit according to at least one embodiment of the present disclosure.
FIG. 6H is a schematic view of a seventh insulating layer of a repeating unit according to at least one embodiment of the present disclosure.
FIG. 7 is another partial schematic view of a transparent display panel according to at least one embodiment of the present disclosure.
FIG. 8 is a schematic diagram of a repeating unit of a transparent display panel according to at least one embodiment of the present disclosure.
FIG. 9 is another partial schematic view of a transparent display panel according to at least one embodiment of the present disclosure.
FIG. 10 is a schematic view of a repeating unit of a transparent display panel according to at least one embodiment of the present disclosure.
FIG. 11 is another partial schematic view of a transparent display panel according to at least one embodiment of the present disclosure.
FIG. 12 is a schematic diagram of a repeating unit of a transparent display panel according to at least one embodiment of the present disclosure.
FIG. 13 is another partial schematic view of a transparent display panel according to at least one embodiment of the present disclosure.
FIG. 14 is a schematic diagram of a repeating unit of a transparent display panel according to at least one embodiment of the present disclosure.
FIG. 15 is another partial schematic view of a transparent display panel according to at least one embodiment of the present disclosure.
FIG. 16 is a schematic diagram of a repeating unit of a transparent display panel according to at least one embodiment of the present disclosure.
FIG. 17 is another partial schematic view of a transparent display panel according to at least one embodiment of the present disclosure.
FIG. 18 is a schematic diagram of a repeating unit of a transparent display panel according to at least one embodiment of the present disclosure.
FIG. 19 is another partial schematic view of a transparent display panel according to at least one embodiment of the present disclosure.
FIG. 20 is a schematic diagram of a repeating unit of a transparent display panel according to at least one embodiment of the present disclosure.
FIG. 21 is a schematic diagram of a display apparatus according to at least one embodiment of the present disclosure.

### Detailed Description

The embodiments of the present disclosure will be described below in combination with the drawings in detail. Implementations may be implemented in a plurality of different forms. Those of ordinary skills in the art may easily understand such a fact that implementation modes and contents may be transformed into one or more forms without departing from the purpose and scope of the present disclosure. Therefore, the present disclosure should not be explained as being limited to contents described in following implementations only. The embodiments in the present disclosure and features in the embodiments may be combined randomly with each other without conflict.

In the drawings, a size of one or more constituent elements, a thickness of a layer, or a region is sometimes exaggerated for clarity. Therefore, one implementation of the present disclosure is not necessarily limited to the dimensions, and shapes and sizes of various components in the drawings do not reflect actual scales. In addition, the drawings schematically illustrate ideal examples, and one implementation of the present disclosure is not limited to the shapes, numerical values, or the like shown in the drawings.

Ordinal numerals such as "first", "second", and "third" in the specification are set to avoid confusion of constituent elements, but not to set a limit in quantity. In the present disclosure, "a plurality of" may include two or more than two.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred apparatus or element must have a particular orientation and be constructed and operated in the particular orientation. Therefore, they cannot be understood as limitations on the present disclosure. The positional relationships between the constituent elements are changed as appropriate based on directions which are used for describing the constituent elements. Therefore, appropriate replacements may be made according to situations without being limited to the wordings described in the specification.

In the specification, unless otherwise specified and defined explicitly, terms "mount", "mutually connect", and "connect" should be understood in a broad sense. For example, it may be a fixed connection, or a detachable connection, or an integrated connection; it may be a mechanical connection, or an electrical connection; it may be a direct mutual connection, or an indirect connection through middleware, or internal communication between two components. Those of ordinary skills in the art may understand meanings of the above-mentioned terms in the present disclosure according to situations.

In the specification, "electrical connection" includes a case where constituent elements are connected together through an element with a certain electrical effect. The "element with the certain electrical effect" is not particularly limited as long as electrical signals may be sent and received between the connected constituent elements. Examples of the "element with the certain electrical effect" not only include electrodes and wirings, but also include switching elements (such as transistors), resistors, inductors, capacitors, other elements with one or more functions, etc.

In the specification, a transistor refers to a component which includes at least three terminals, i.e., a gate electrode, a drain electrode and a source electrode. The transistor has a channel region between the drain electrode (drain electrode terminal, drain region, or drain) and the source electrode (source electrode terminal, source region, or source), and a current can flow through the drain electrode, the channel region and the source electrode. In the present disclosure, the channel region refers to a region which the current flows mainly through.

In this specification, for distinguishing the two electrodes, except the gate, of the transistor, one electrode is called a first electrode, and the other electrode is called a second electrode. The first electrode may be the source or the drain, and the second electrode may be the drain or the source. In addition, a gate of the transistor may be called a control electrode. In a case where transistors with opposite polarities are used, or a current direction changes during operation of a circuit, or the like, functions of the "source electrode" and the "drain electrode" are sometimes interchangeable. Therefore, the "source electrode" and the "drain electrode" are interchangeable in the specification.

In the specification, "parallel" refers to a state in which an angle formed by two straight lines is -10° or more and 10° or less, and thus may include a state in which the angle is -5° or more and 5° or less. In addition, "perpendicular" refers to a state in which an angle formed by two straight lines is 80° or more and 100° or less, and thus may include a state in which the angle is 85° or more and 95° or less.

Triangle, rectangle, trapezoid, pentagon and hexagon in this specification are not strictly defined, and they may be approximate triangle, rectangle, trapezoid, pentagon or hexagon, etc. There may be some small deformation caused by tolerance, and there may be chamfer, arc edge and deformation, etc.

In the specification, a "film" and a "layer" are interchangeable. For example, a "conductive layer" may be replaced with a "conductive film" sometimes. Similarly, an "insulating film" may be replaced with an "insulation layer" sometimes.

In this specification, "about" and "substantially" refer to a case where a boundary is not defined strictly and a process and measurement error within a range is allowed. In this specification, "substantially the same" could be a case where values differ by less than 10%.

In the present disclosure, "thickness" and "height" refer to a vertical distance between a surface of a side of a film layer away from the substrate and a surface of a side close to the substrate.

In some implementations, the transparent display panel includes a transmissive region and a non-transmissive region. Herein, the transmissive region and the non-transmissive region may be arranged alternately. If an area of part of the transmissive regions is too small and the distribution thereof is periodic, based on the principle of small-hole diffraction, the diffraction phenomenon will occur, and the smaller the size of the transmissive region, the more obvious the diffraction phenomenon is. In the related technology, without changing the wiring design, with the increase of the resolution (PPI, Pixels Per Inch) of the transparent display panel, the area of each transmissive region decreases, and strong diffraction occurs when the ambient light passes through the transparent display panel, which leads to obvious ghosting when the picture of the transparent display panel are viewed, and reduces the display quality of the transparent display panel.

An embodiment provides a transparent display panel including a substrate and a plurality of repeating units arranged in an array on the substrate. The repeating units include a non-transmissive region and a plurality of transmissive sub-regions, and adjacent transmissive sub-regions are spaced apart by the non-transmissive region. The non-transmissive region includes: at least one pixel unit and N sets of first traces extending in a first direction and M sets of second traces extending in a second direction electrically connected to the pixel unit. The first direction intersects the second direction, for example, the first direction may be perpendicular to the second direction. N and M are both positive integers, and N and M are not both greater than 1. For example, N and M may both be 1; alternatively, N may be 1 and M may be greater than 1; alternatively, M may be 1 and N may be greater than 1.

In some examples, at least one set of first traces includes: a plurality of first signal lines and at least one second signal line. An orthographic projection of the at least one second signal line on the substrate covers an orthographic projection of at least two first signal lines on the substrate. Alternatively, at least one set of second traces include: a plurality of third signal lines and at least one fourth signal line. An orthographic projection of at least one fourth signal line on the substrate covers an orthographic projection of at least two third signal lines on the substrate. In this example, the plurality of signal lines within each set of traces take an aggregation design. A superimposition design is used for signal lines located in different film layers in a set of first traces or a set of second traces.

In the present disclosure, using a superimposition design for two structures means that orthographic projections of the two structures overlap and that more than 90% of the orthographic projection of one of the structures may fall within the orthographic projection of the other. Aggregation design means that a plurality of signal lines are arranged in a centralized manner, for example, a spacing between two adjacent signal lines of the plurality of signal lines arranged in a centralized manner is less than twice the line width of any one of the two signal lines. The region between adjacent signal lines located in the same film layer and using an aggregation design may be ignored and not be counted in the transmissive region. For example, the spacing between adjacent signal lines located in the same film layer and using an aggregation design may be about 3 microns to 5 microns.

In some examples, a non-transmissive region is a region where pixel units or signal traces, etc., for displaying images are present and background light on the back side of the transparent display panel cannot be transmitted or background light transmittance is small. The transmissive region is a region where pixel units or signal traces, etc., for displaying images are not present and background light on the back side of the transparent display panel can be transmitted or background light transmittance is large. The transmissive region of the present disclosure does not include a region between adjacent signal lines using an aggregation design, for example, if the spacing between two adjacent signal lines exceeds at least five times the line width of any one of the two lines, a region between the two adjacent signal lines constitutes the transmissive region.

In the present disclosure, structure A extends in a direction B means that structure A may include a main body portion and a secondary portion connected to the main body portion, the main body portion is substantially in the shape of a strip extending in one direction, the secondary portion is of any shape, the main body portion is at least 60% of structure A; the main body portion extends in the direction B, and a size of the main body portion extending in the direction B is larger than that of the secondary portion extending in another direction. In the following description, the expression "structure A extends in a direction B" means that the main body portion of structure A extends in the direction B.

The transparent display panel provided in this embodiment, using the superimposition design of signal traces, can achieve increased transmissive region, reduced diffraction, and improved display sharpness while ensuring the transmittance of the transparent display panel, thereby improving the transmittance and display quality of the transparent display panel.

In some exemplary embodiments, a pixel unit may include three sub-pixels. The three sub-pixels may be a red sub-pixel, a green sub-pixel, and a blue sub-pixel, respectively. However, this embodiment is not limited thereto. In some examples, a pixel unit may include four sub-pixels, and the four sub-pixels may be a red sub-pixel, a green sub-pixel, a blue sub-pixel, and a white sub-pixel, respectively. In some examples, the sub-pixel may be shaped into a rectangle, a rhombus, a pentagon, or a hexagon. When a pixel unit includes three sub-pixels, the three sub-pixels may be spaced in a certain direction sequentially, alternatively, may be arranged in a shape of a Chinese character " 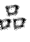 ". When a pixel unit includes four sub-pixels, the four sub-pixels may be spaced in a certain direction sequentially or arranged in an array. However, this embodiment is not limited thereto.

In some examples, each sub-pixel may include: a pixel circuit and a light emitting element connected to the pixel circuit. An orthographic projection of the light emitting element of the sub-pixel on the substrate may overlap with an orthographic projection of the electrically connected pixel circuit of the sub-pixel on the substrate. This example can increase the area of the transmissive region and improve transmittance by using a superimposition design for the light emitting element and the pixel circuit.

In some examples, the pixel circuit may include a plurality of transistors and at least one capacitor. For example, the pixel circuit may be a 3T1C structure, a 7T1C structure, a 5T1C structure, an 8T1C structure, or an 8T2C structure, etc., wherein T in the above circuit structure refers to a thin film transistor, C refers to a capacitor, the number in front of T represents the number of thin film transistors in the circuit, and the number in front of C represents the number of capacitors in the circuit.

In some examples, the light emitting element may be an element with a light emitting area no larger than 1 × 10⁵ um², such as a micro light emitting diode (Micro-LED), or a mini diode (Mini-LED), or an organic light emitting diode (OLED), or Quantum dot Light Emitting Diode (QLED).

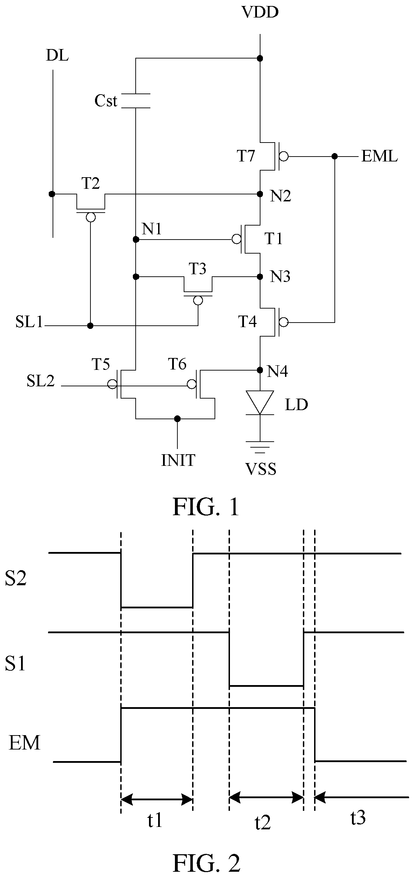

FIG. 1 is an equivalent circuit diagram of a pixel circuit according to at least one embodiment of the present disclosure. In some examples, as shown in FIG. 1, the pixel circuit of this example may have a structure of 7T1C, i.e., first transistor T1 to seventh transistor T7 and a storage capacitor Cst. A gate of the first transistor T1 is electrically connected to a first node N1, a first electrode of the first transistor T1 is electrically connected to a second node N2, and a second electrode of the first transistor T1 is electrically connected to a third node N3. The first transistor T1 may also be referred to as a drive transistor. A gate of the second transistor T2 is electrically connected to a first scan line SL1, a first electrode of the second transistor T2 is electrically connected to a data line DL, and a second electrode of the second transistor T2 is electrically connected to the second node N2. The second transistor T2 may also be referred to as a data writing transistor. A gate of the third transistor T3 is electrically connected to the first scan line SL1, a first electrode of the third transistor T3 is electrically connected to the first node N1, and a second electrode of the third transistor T3 is electrically connected to the third node N3. The third transistor T3 may also be referred to as a threshold compensation transistor. A gate of the fourth transistor T4 is electrically connected to a light emitting control line EML, a first electrode of the fourth transistor T4 is electrically connected to the third node N3, and a second electrode of the fourth transistor T4 is electrically connected to a fourth node N4. A gate of the seventh transistor T7 is electrically connected to the light emitting control line EML, a first electrode of the seventh transistor T7 is electrically connected to a first power supply line VDD, and a second electrode of the seventh transistor T7 is electrically connected to the second node N2. The fourth transistor T4 and the seventh transistor T7 may also be referred to as light emitting control transistors. A gate of the fifth transistor T5 is electrically connected to a second scan line SL2, a first electrode of the fifth transistor T5 is electrically connected to an initial signal line INIT, and the second electrode of the fifth transistor T5 is electrically connected to the first node N1. A gate of the sixth transistor T6 is electrically connected to the second scan line SL2, a first electrode of the sixth transistor T6 is electrically connected to the initial signal line INIT, and a second electrode of the sixth transistor T6 is electrically connected to the fourth node N4. The fifth transistor T5 and the sixth transistor T6 may also be referred to as reset control transistors. A first capacitor plate of the storage capacitor Cst is electrically connected to the first node N1, and a second capacitor plate of the storage capacitor Cst is electrically connected to the first power supply line VDD. A first electrode of the light emitting element LD is electrically connected to the fourth node N4, and the second electrode of the light emitting element LD is electrically connected to a second power supply line VSS. For example, the first electrode of the light emitting element LD may be an anode, and the second electrode of the light emitting element LD may be a cathode.

In this example, the first node N1 may be a connection point of the storage capacitor Cst, the first transistor T1, the third transistor T3, and the fifth transistor T5. The second node N2 may be a connection point of the first transistor T1, the second transistor T2, and the seventh transistor T7. The third node N3 may be a connection point of the first transistor T1, the third transistor T3 and the fourth transistor T4. The fourth node N4 may be a connection point of the fourth transistor T4, the sixth transistor T6 and the light emitting element LD.

In some examples, the first transistor T1 to the seventh transistor T7 may all be P-type transistors, or all may be N-type transistors. Use of transistors of a same type in a pixel circuit may simplify a process flow, reduce process difficulties of a transparent display panel, and improve a product yield. In some possible implementations, some of the transistors in the first transistor T1 to the seventh transistor T7 may be N-type transistors (e.g., the third transistor T3 and the fifth transistor T5), and the remaining transistors may be P-type transistors.

In some examples, the first power supply line VDD may be configured to provide a constant first voltage signal to the pixel circuit, and the second power supply line VSS may be configured to provide a constant second voltage signal to the pixel circuit. The first voltage signal may be greater than the second voltage signal. The first scan line SL1 may be configured to provide a first scan signal S1 to the pixel circuit, and the second scan line SL2 may be configured to provide a second scan signal S2 to the pixel circuit. In some examples, the second scan line electrically connected to the nth row of pixel circuits may be electrically connected to the first scan line of the (n-1)th row of pixel circuits, to be input with the first scan signal S1 (n-1), i.e., the second scan signal S2 (n) may be the same as the first scan signal S1 (n-1), and n may be an integer greater than 0. In this way, the signal lines of the transparent display panel can be reduced to achieve a narrow bezel design of the transparent display panel. The data line DL may be configured to provide data signals to the pixel circuit. The light emitting control line EML may be configured to provide the light emitting control signal EM to the pixel circuit. The initial signal line INIT may be configured to provide an initial signal to the pixel circuit. The size of the initial signal may be between, but not limited to, the first voltage signal and the second voltage signal.

The working process of the pixel circuit is explained below. FIG. 2 is a working timing diagram of the pixel circuit shown in FIG. 1. The description is made by taking a case in which multiple transistors included in the pixel circuit shown in FIG. 1 are all P-type transistors as an example.

In some exemplary implementations, as shown in FIG. 2, the working process of the pixel circuit may include a first time period t1, a second time period t2, and a third time period t3 during a frame display duration.

In the first time period t1, the second scan line SL2 provides a second scan signal S2 of a low level, and the fifth transistor T5 and the sixth transistor T6 are turned on. The fifth transistor T5 is turned on, to provide an initial signal to the first node N1 to initialize the first node N1, and the sixth transistor T6 is turned on, to provide an initial signal to the fourth node N4 to initialize the fourth node N4. The light emitting control line EML provides a light emitting control signal EM of a high level, and the fourth transistor T4 and the seventh transistor T7 are turned off. The first scan line SL1 provides a first scan signal S2 of a high level, and the second transistor T2 and the third transistor T3 are turned off.

In the second time period t2, the first scan line SL1 provides a first scan signal S1 of a low level, the second transistor T2 and the third transistor T3 are turned on, and the first transistor T1 may be connected in the form of a diode through the third transistor T3. The data line DL provides a data signal, which is transmitted to the first node N1 via the second transistor T2, the first transistor T1 and the third transistor T3. The first transistor T1 is connected in the form of a diode, so that a difference between a voltage of the data signal and a threshold voltage of the first transistor T1 is transmitted to the first node N1, and the voltage of the first node N1 is stored in the storage capacitor Cst.

In the third time period t3, the first scan line SL1 provides a first scan signal S1 of a high level, the second scan line SL2 provides a second scan signal S2 of a high level, and the light emitting control line EML provides a light emitting control signal EM of a low level. The fourth transistor T4 and the seventh transistor T7 are turned on, and a drive current flows from the first power supply line VDD through the seventh transistor T7, the first transistor T1, the fourth transistor T4 and the light emitting element LD to the second power supply line VSS. The drive current is controlled by the voltage of the first node N1, and the voltage of the data signal and a voltage corresponding to the threshold voltage of the first transistor T1 may offset the threshold voltage of the first transistor T1 in the fourth time period t4, so that the drive current corresponds to the data signal and is irrelevant to the threshold voltage offset of the first transistor T1. The pixel circuit according to the present embodiment may better compensate the threshold voltage of the first transistor T1.

Solutions of this embodiment will be described below through multiple examples.

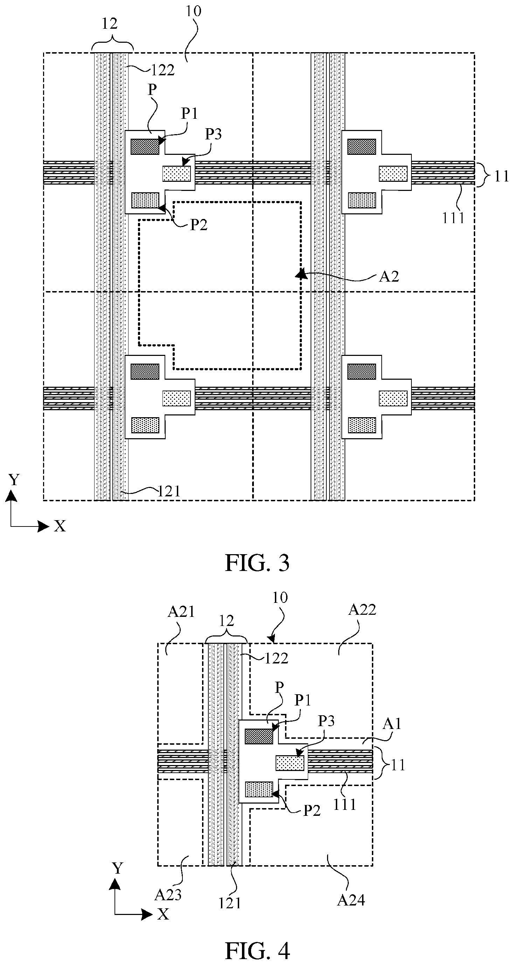

FIG. 3 is a partial schematic diagram of a transparent display panel according to at least one embodiment of the present disclosure. FIG. 4 is a schematic diagram of a repeating unit of a transparent display panel according to at least one embodiment of the present disclosure. FIG. 3 is formed by four repeating units shown in FIG. 4 arranged in a 2 × 2 array.

In some examples, as shown in FIGS. 3 and 4, the transparent display panel may include a plurality of repeating units 10 arranged in an array on a substrate. For example, the repeating units 10 are substantially quadrilateral, for example rectangular. Each repeating unit 10 may include a non-transmissive region A1 and a plurality of transmissive sub-regions (including, for example, a first transmissive sub-region A21, a second transmissive sub-region A22, a third transmissive sub-region A23, and a fourth transmissive sub-region A24), and adjacent transmissive sub-regions may be spaced apart by the non-transmissive region A1. The non-transmissive regions A1 of adjacent repeating units 10 may be interconnected; the transmissive sub-regions of adjacent repeating units 10 may be interconnected to each other. For example, the transmissive sub-regions of four repeating units 10 arranged in a 2 × 2 array may be interconnected to form a larger transmissive region A2. For example, the fourth transmissive sub-region A24 of the repeating unit in the first row and the first column, the third transmissive sub-region A23 of the repeating unit in the first row and the second row, the second transmissive sub-region A22 of the repeating unit in the second row and the first column, and the first transmissive sub-region A21 of the repeating unit in the second row and the second column may be interconnected to form a larger transmissive region A2. The transmissive region A2 may be surrounded by the non-transmissive regions A1.

In some examples, the total area of the transmissive sub-region in a repeating unit may be greater than the area of the non-transmissive region. The total area of the transmissive region of the transparent display panel may be greater than 45% of the total area of the transparent display panel, for example, it may be about 48.5%, 79.3%, 82.1%, or 85%. However, this embodiment is not limited thereto. In some examples, an area ratio of the transmissive region may be set according to the actual application requirements. The larger the area ratio of the transmissive region, the greater the transmittance of the transparent display panel, and the higher the transparency of the transparent display panel, i.e., the better the transparent display effect.

In some examples, as shown in FIGS. 3 and 4, the non-transmissive region A1 of a repeating unit 10 may include: a pixel unit P and a set of first traces 11 and a set of second traces 12 electrically connected to the pixel unit P. The set of first traces 11 may include: a plurality of first signal lines 111 extending in a first direction X. The plurality of first signal lines 111 may be sequentially arranged in a second direction Y. The plurality of first signal lines 111 may be of a structure of a same layer. The set of second trace 12 may include a plurality of third signal lines 121 and a plurality of fourth signal lines 122 extending in the second direction Y. The plurality of third signal lines 121 may be arranged sequentially in the first direction X, and the plurality of fourth signal lines 122 may be arranged sequentially in the first direction X. The plurality of third signal lines 121 may be of a structure of a same layer, and the plurality of fourth signal lines 122 may be of a structure of a same layer. For example, the plurality of fourth signal lines 122 may be located on a side of the plurality of third signal lines 121 away from the substrate. The orthographic projection of at least one fourth signal line 122 on the substrate may cover the orthographic projection of at least two third signal lines 121 on the substrate. For example, the orthographic projection of one fourth signal line 122 on the substrate may cover the orthographic projection of two third signal lines 121 on the substrate. In some examples, a plurality of fourth signal lines 122 of the set of second traces 12 may include: a first power supply line and a second power supply line. The second power supply line may be located on a side of the first power supply line near the pixel unit P in the first direction X. In other words, the second power supply line may be adjacent to the pixel unit P, and the first power supply line may be located on a side of the second power supply line away from the pixel unit P.

In some examples, as shown in FIG. 3, the plurality of repetition units 10 are arranged in an array such that the non-transmissive regions A1 of adjacent repetition units 10 may be interconnected. A plurality of first signal lines 111 within the non-transmissive regions A1 of the repetition units 10 adjacent in a first direction X may be correspondingly interconnected, a plurality of third signal lines 121 within the non-transmissive regions A1 of the repetition units 10 adjacent in a second direction Y may be correspondingly interconnected, and a plurality of fourth signal lines 122 may be correspondingly interconnected. After the plurality of repetition units 10 are arranged in an array, the plurality of first signal lines 111 may transmit signals in the first direction X, and the plurality of third signal lines 121 and the plurality of fourth signal lines 122 may transmit signals in the second direction Y.

In some examples, as shown in FIGS. 3 and 4, a pixel unit P within the non-transmissive region A1 of the repeating unit 10 may include a first sub-pixel P1 emitting light of a first color, a second sub-pixel P2 emitting light of a second color, and a third sub-pixel P3 emitting light of a third color. The first sub-pixel P1, the second sub-pixel P2, and the third sub-pixel P3 may be arranged in a shape of a Chinese character " 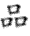 ". For example, the light of the first color may be red light, the light of the second color may be blue light, and the light of the third color light may be green light. However, this embodiment is not limited thereto.

In some examples, the first sub-pixel P1 may include: a first pixel circuit and a first light emitting element electrically connected to the first pixel circuit. A second sub-pixel P2 may include: a second pixel circuit and a second light emitting element electrically connected to the second pixel circuit. The third sub-pixel P3 may include: a third pixel circuit and a third light emitting element electrically connected to the third pixel circuit. The orthographic projection of the first light emitting element on the substrate overlaps with the orthographic projection of the first pixel circuit on the substrate. The orthographic projection of the second light emitting element on the substrate overlaps with the orthographic projection of the second pixel circuit on the substrate. The orthographic projection of the third light emitting element on the substrate overlaps with the orthographic projection of the third pixel circuit on the substrate. For example, the first pixel circuit, the second pixel circuit and the third pixel circuit may be of the 7T1C structure as shown in FIG. 1, and the first light emitting element, the second light emitting element and the third light emitting element may be elements with a light emitting area no larger than 1×10⁵ um², such as a micro-LED. In this example, the superimposition design of the pixel circuit and the corresponding electrically connected light emitting element can reduce the area of the non-transmissive region A1 and increase the pixel opening ratio, thereby increasing the area of the transmissive region.

In some examples, the sizes of the first transistors in the pixel circuits electrically connected to the light emitting elements emitting light of different colors may be different due to differences in the optoelectronic properties of the light emitting elements emitting light of different colors. For example, a channel aspect ratio (i.e., a ratio of a size in the first direction to a size in the second direction) of the first transistor of the pixel circuit electrically connected to the light emitting element emitting red light may be greater than a channel aspect ratio of the first transistor of the pixel circuit electrically connected to the light emitting element emitting blue or green light.

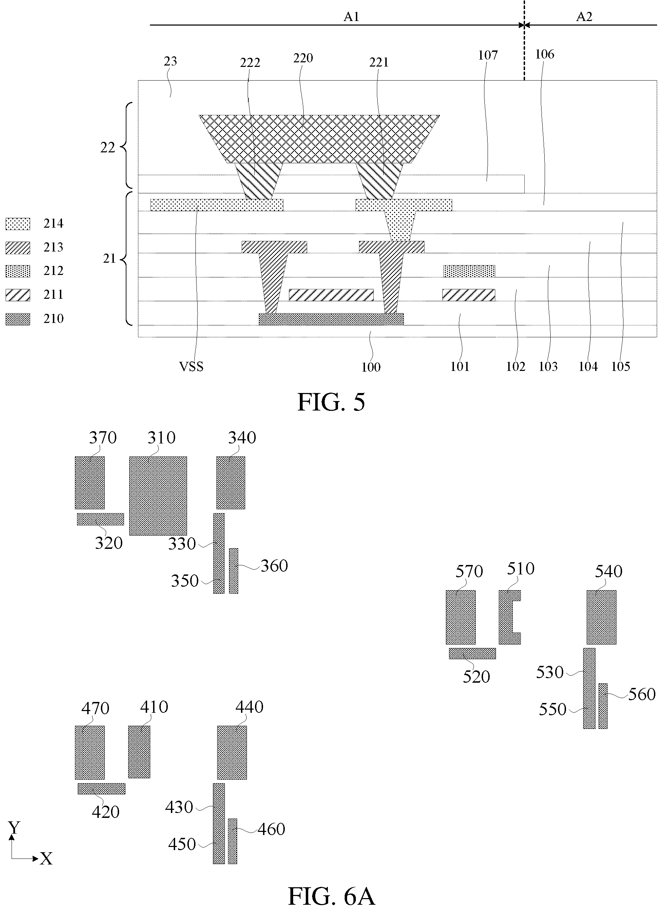

FIG. 5 is a schematic partial sectional view of a transparent display panel according to at least one embodiment of the present disclosure. In some examples, as shown in FIG. 5, in a direction perpendicular to the transparent display panel, the non-transmissive region A1 of the repeating unit may include: a substrate 100, and a circuit structure layer 21, a light emitting structure layer 22, and a cover layer 23 disposed sequentially on the substrate 100. The circuit structure layer 21 may include at least: a plurality of pixel circuits (e.g., a first pixel circuit, a second pixel circuit, and a third pixel circuit). The circuit structure layer 21 in FIG. 5 is illustrated by taking only a partial structure of a transistor and a storage capacitor of a pixel circuit as an example. The circuit structure layer 21 may include: a semiconductor layer 210, a first conductive layer 211, a second conductive layer 212, a third conductive layer 213, and a fourth conductive layer 214 disposed sequentially on the substrate 100. In some examples, the semiconductor layer 210 may include active layers of transistors of the plurality of pixel circuits. The first conductive layer 211 may include at least: gates of the transistors of the plurality of pixel circuits and a capacitor plate of a storage capacitor. The second conductive layer 212 may include at least: another capacitor plate of the storage capacitor of the plurality of pixel circuits. The third conductive layer 213 may include at least: a plurality of connection electrodes. The fourth conductive layer 214 may include at least: a first conductive part, a second conductive part, and a second power supply line VSS.

In some examples, as shown in FIG. 5, a first insulating layer 101 may be provided between the semiconductor layer 210 and the first conductive layer 211, a second insulating layer 102 may be provided between the first conductive layer 211 and the second conductive layer 212, a third insulating layer 103 may be provided between the second conductive layer 212 and the third conductive layer 213, and a fourth insulating layer 104 and a fifth insulating layer 105 may be provided between the third conductive layer 213 and the fourth conductive layer 214. A sixth insulating layer 106 and a seventh insulating layer 107 may be provided on a side of the fourth conductive layer 214 away from the substrate 100. For example, the first insulating layer 101 to the fourth insulating layers 104 and the sixth insulating layer 106 may be inorganic insulating layers, and the fifth insulating layer 105 and the seventh insulating layer 107 may be organic insulating layers. However, this embodiment is not limited thereto.

In some examples, the light emitting structure layer 22 may include: a plurality of light emitting elements (e.g., a first light emitting element, a second light emitting element, and a third light emitting element). Taking a light emitting element as an example, as shown in FIG. 5, the light emitting element may include: a light emitting part 220, a first electrode 221and a second electrode 222 connected to the light emitting part 220. The first electrode 221 is connected to a first end of the light emitting part 220, and the second electrode 222 is connected to a second end of the light emitting part 220. For example, the first electrode 221 of the light emitting element may be an anode, and the second electrode 222 thereof may be a cathode. The first electrode 221 may be electrically connected to the pixel circuit through the first conductive part, and the second electrode 222 may be electrically connected to the second power supply line VSS through the second conductive part. However, this embodiment is not limited thereto. A protective layer 23 may also be provided on a side of the light emitting element away from the substrate 100, to prevent the light emitting element from falling off due to external force (e.g., rubbing) in the subsequent process or transportation. The material of the protective layer 23 may be silicone.

In some examples, as shown in FIG. 5, in a direction perpendicular to the transparent display panel, the transmissive region A2 may include: a substrate 100, a first insulating layer 101 to a sixth insulating layer 106 disposed sequentially on the substrate 100, and a cover layer 23. The seventh insulating layer 107 may be hollowed out in the transmissive region A2 to enhance the transmittance of the transmissive region A2. However, this embodiment is not limited thereto. In some other examples, the fifth insulating layer and the seventh insulating layer may be hollowed out in the transmissive region A2 to further enhance the transmittance of the transmissive region A2.

A preparation process of the transparent display panel will be exemplarily described below. The "patterning process" or "a process of patterning" mentioned in the present disclosure includes processings, such as photoresist coating, mask exposure, development, etching and photoresist stripping, for metal materials, inorganic materials or transparent conductive materials, and includes processings, such as organic material coating, mask exposure and development, for organic materials. Deposition may be any one or more of sputtering, evaporation, and chemical vapor deposition. Coating may be any one or more of spray coating, spin coating, and ink-jet printing. Etching may be any one or more of dry etching and wet etching, which are not limited in present disclosure. A "thin film" refers to a layer of thin film made of a material on a base substrate through a process such as deposition, coating, etc. If the "thin film" does not need a patterning process in an entire preparation process, the "thin film" may also be called a "layer". If the "thin film" needs a patterning process in an entire preparation process, it is called a "thin film" before the patterning process, and called a "layer" after the patterning process. The "layer" after the patterning process includes at least one "pattern".

"E and F are disposed on the same layer " in the present disclosure means that E and F are formed simultaneously by the same patterning process or that the surfaces of E and F near the substrate are at substantially the same distance from the substrate, or that the surfaces of E and F near the substrate are in direct contact with the same film layer. The "thickness" of the film layer is a size of the film layer in a direction perpendicular to a plane where the substrate is located. In an exemplary embodiment of the present disclosure, "an orthogonal projection of E includes an orthogonal projection of F" refers to that a boundary of the orthogonal projection of E falls within a boundary of the orthogonal projection of F, or the boundary of the orthogonal projection of E is coincided with the boundary of the orthogonal projection of F.

In some exemplary implementations, a preparation process of a transparent display panel may include following operations.
(1) Providing a substrate. In some examples, the substrate may be a rigid base substrate, such as a glass base substrate or a quartz base substrate, alternatively, it may be a flexible base substrate, such as an organic resin base substrate. In some examples, the substrate may be a glass base substrate. However, this embodiment is not limited thereto.
(2) Forming a semiconductor layer. In some examples, a semiconductor film is deposited on the substrate, and the semiconductor film is patterned by a patterning process to form a semiconductor layer in the non-transmissive region.

FIG. 6A is a schematic diagram of a semiconductor layer of a repeating unit according to at least one embodiment of the present disclosure. In some examples, as shown in FIG. 6A, the semiconductor layer of the non-transmissive region of the repeating unit may include at least: active layers of a plurality of transistors of a plurality of pixel circuits (including, for example, a first active layer 310 of the first transistor to a seventh active layer 370 of the seventh transistor in the first pixel circuit, a first active layer 410 of the first transistor to a seventh active layer 470 of the seventh transistor in the second pixel circuit, and a first active layer 510 of the first transistor to a seventh active layer 570 of the seventh transistor in the third pixel circuit). For example, the third active layer 330 and the fifth active layer 350 of the first pixel circuit may be of an integrated structure, the third active layer 430 and the fifth active layer 450 of the second pixel circuit may be of an integrated structure, and the third active layer 530 and the fifth active layer 550 of the third pixel circuit may be of an integrated structure.

In some examples, the semiconductor layer may be made of one or more materials such as amorphous Indium Gallium Zinc Oxide (a-IGZO), Zinc Oxynitride (ZnON), Indium Zinc Tin Oxide (IZTO), amorphous Silicon (a-Si), polysilicon (p-Si), sexithiophene, and polythiophene. That is, the present disclosure is applicable to transistors manufactured based on an oxide technology, a silicon technology, and an organic matter technology. For example, the material of the semiconductor layer may be polycrystalline silicon (p-Si). However, this embodiment is not limited thereto.

(3) Forming a first conductive layer. In some examples, a first insulating film is deposited on the substrate on which the aforementioned structures are formed, and the first insulating film is patterned by a patterning process to form a first insulating layer covering the semiconductor layer. Subsequently, a first conductive film is deposited, and the first conductive film is patterned by a patterning process to form the first conductive layer in the non-transmissive region.

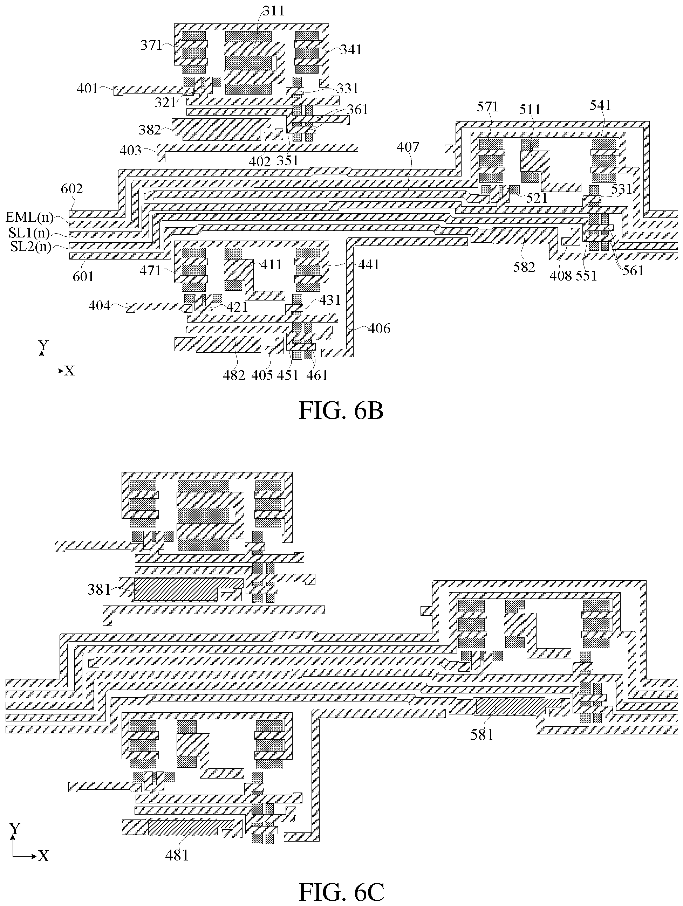

FIG. 6B is a schematic diagram of a first conductive layer of a repeating unit according to at least one embodiment of the present disclosure. In some examples, as shown in FIG. 6B, the first conductive layer of the non-transmissive region of the repeating unit may include at least: gates of a plurality of transistors of a plurality of pixel circuits and a capacitor plate of a storage capacitor (including, for example, a gate 311 of the first transistor, a gate 321 of the second transistor, a gate 331 of the third transistor, a gate 341 of the fourth transistor, a gate 351 of the fifth transistor, a gate 361 of the sixth transistor, a gate 371 of the seventh transistor and a second capacitor plate 382 of the storage capacitor, of the first pixel circuit; a gate 411 of the first transistor, a gate 421 of the second transistor, a gate 431 of the third transistor, a gate 441 of the fourth transistor, a gate 451 of the fifth transistor, a gate 461 of the sixth transistor, a gate 471 of the seventh transistor, and a second capacitor plate 482 of the storage capacitor, of the second pixel circuit; a gate 511 of the first transistor, a gate 521 of the second transistor, a gate 531 of the third transistor, a gate 541 of the fourth transistor, a gate 551 of the fifth transistor, a gate 561 of the sixth transistor, a gate 571 of the seventh transistor, and a second capacitor plate 582 of the storage capacitor, of the third pixel circuit) , a plurality of connection electrodes (e.g., a first connection electrode 401 to an eighth connection electrode 408), a light emitting control line EML(n), a first scan line SL1(n), a second scan line SL2(n), a first power connection line 601, and a second power connection line 602.

In some examples, as shown in FIG. 6B, in the first pixel circuit, the gate 341 of the fourth transistor and the gate 371 of the seventh transistor may be of an integrated structure, the gate 321 of the second transistor and the gate 331 of the third transistor may be of an integrated structure, and the gate 351 of the fifth transistor and the gate 361 of the sixth transistor may be of an integrated structure. The first transistor to the seventh transistor of the first pixel circuit may all be dual-gate transistors. In the second pixel circuit, the gate 441 of the fourth transistor and the gate 471 of the seventh transistor may be of an integrated structure, the gate 421 of the second transistor and the gate 431 of the third transistor may be of an integrated structure, and the gate 451 of the fifth transistor and the gate 461 of the sixth transistor may be of an integrated structure. The first transistor to the seventh transistor of the second pixel circuit may all be dual-gate transistors. In the third pixel circuit, the gate 541 of the fourth transistor and the gate 571 of the seventh transistor may be of an integrated structure, the gate 521 of the second transistor and the gate 531 of the third transistor may be of an integrated structure, and the gate 551 of the fifth transistor and the gate 561 of the sixth transistor may be of an integrated structure. The first transistor to the seventh transistor of the third pixel circuit may all be dual-gate transistors. This example can enhance the driving ability, improve the current saturation of the light emitting element, and prevent and reduce the occurrence of leakage current by using dual-gate transistors.

In some examples, as shown in FIG. 6B, the second power connection line 602, the light emitting control line EML(n), the first scan line SL1(n), the second scan line SL2(n), and the first power connection line 601 may be arranged sequentially in the second direction Y and extend in the first direction X. The second power connection line 602, the light emitting control line EML(n), the first scan line SL1(n), the second scan line SL2(n), and the first power connection line 601 may be located between the first pixel circuit and the second pixel circuit in the second direction Y.

In some examples, the first power connection line 601 and the second capacitor plate 582 of the storage capacitor of the third pixel circuit may be of an integrated structure as shown in FIG. 6B. The light emitting control line EML(n) and the gate 571 of the seventh transistor and the gate 541 of the fourth transistor of the third pixel circuit may be of an integrated structure. The first scan line SL1(n) and the gate 521 of the second transistor and the gate 531 of the third transistor of the third pixel circuit may be of an integrated structure. The second scan line SL2(n) and the gate 551 of the fifth transistor and the gate 561 of the sixth transistor of the third pixel circuit may be of an integrated structure. However, this embodiment is not limited thereto.

(4) Forming a second conductive layer. In some examples, a second insulating film is deposited on the substrate on which the aforementioned structures are formed, and the second insulating film is patterned by a patterning process to form a second insulating layer covering the first conductive layer; subsequently, a second conductive film is deposited, and the second conductive film is patterned by a patterning process to form a second conductive layer in the non-transmissive region.

FIG. 6C is a schematic diagram of a second conductive layer of a repeat unit according to at least one embodiment of the present disclosure. In some examples, as shown in FIG. 6C, the second conductive layer of the non-transmissive region of the repeating unit may include at least: the other capacitor plates of the storage capacitors of the plurality of pixel circuits (including, for example, a first capacitor plate 381 of the storage capacitor of the first pixel circuit, a first capacitor plate 481 of the storage capacitor of the second pixel circuit, and a first capacitor plate 581 of the third pixel circuit).

(5) Forming a third insulating layer. In some examples, a third insulating film is deposited on the substrate on which the aforementioned structures are formed, and the third insulating film is patterned by a patterning process to form a third insulating layer.

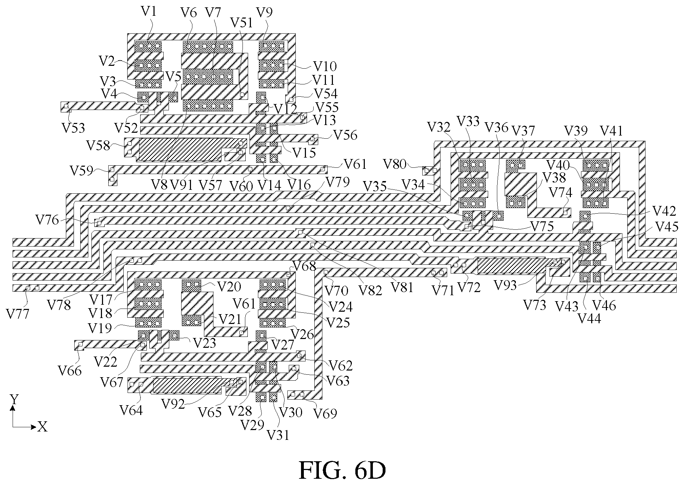

FIG. 6D is a schematic diagram of a third insulating layer of a repeating unit according to at least one embodiment of the present disclosure. In some examples, as shown in FIG. 6D, the third insulating layer of the non-transmissive region of the repeating unit is opened with a plurality of vias, which may include, for example, a first via V1 to forty-sixth via V46 exposing the surface of the semiconductor layer, a fifty-first via V51 to eighty-second via V82 exposing the surface of the first conductive layer, a ninety-first via V91 to ninety-third via V93 exposing the surface of the second conductive layer.

(6) Forming a third conductive layer. In some examples, a third conductive film is deposited on the substrate on which the aforementioned structures are formed, and the third conductive film is patterned by a patterning process to form a third conductive layer in the non-transmissive region.

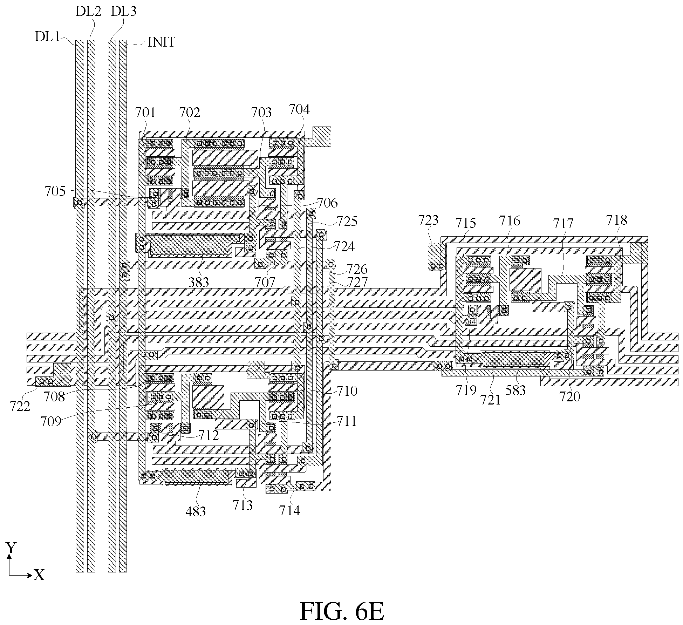

FIG. 6E is a schematic diagram of the third conductive layer of a repeating unit according to at least one embodiment of the present disclosure. In some examples, as shown in FIG. 6E, the third conductive layer of the non-transmissive region of the repeating unit may include at least: a plurality of connection electrodes (e.g., eleventh connection electrode 701 to thirty-seventh connection electrode 727), a third capacitor plate 383 of the first pixel circuit, a third capacitor plate 483 of the second pixel circuit, a third capacitor plate 583 of the third pixel circuit, a plurality of data lines (e.g. data line DL1 to data line DL3), and an initial signal line INIT.

In some examples, as shown in FIG. 6E, data line DL1 to data line DL3, and the initial signal line INIT may be adjacent and arranged sequentially in a first direction X, and all extend in a second direction Y. The data line DL1 to data line DL3, and the initial signal line INIT may be located on a side of the first pixel circuit and the second pixel circuit away from the third pixel circuit in the first direction X. The orthographic projection of the data line DL1 to data line DL3 and the initial signal line INIT located in the third conductive layer on the substrate may overlap with the orthographic projection of the light emitting control line EML(n), the first scan line SL1(n), the second scan line SL2(n), the first power connection line 601 and the second power connection line 602 located in the first conductive layer on the substrate.

In some examples, as shown in FIGS. 6A to 6E, the eleventh connection electrode 701 may be electrically connected to the seventh active layer 370 of the seventh transistor of the first pixel circuit through three first vias V1 arranged side by side and three third vias V3 arranged side by side, and may also be electrically connected to the second capacitor plate 382 through two fifty-eighth vias V58 arranged vertically. The eleventh connection electrode 701 and the third capacitor plate 383 may be of an integrated structure. The twelfth connection electrode 702 may be electrically connected to the first active layer 310 of the first transistor of the first pixel circuit through six sixth vias V6 arranged side by side and six eighth vias V8 arranged side by side, and may also be electrically connected to the seventh active layer 370 of the seventh transistor through three second vias V2 arranged side by side, and may also be electrically connected to the second active layer 320 of the second transistor through the fifth via V5. The thirteenth connection electrode 703 may be electrically connected to the first active layer 310 of the first transistor through six seventh vias V7 arranged side by side, and may also be electrically connected to the fourth active layer 340 of the fourth transistor through three tenth vias V10 arranged side by side, and may also be electrically connected to the third active layer 330 of the third transistor through the twelfth via V12. The fourteenth connection electrode 704 may be electrically connected to the fourth active layer 340 of the fourth transistor through three ninth vias V9 arranged side by side and three eleventh vias V11 arranged side by side, and may also be electrically connected to the sixth active layer 360 of the sixth transistor through the fifteenth vias V15. The fifteenth connection electrode 705 may be electrically connected to the second active layer 320 of the second transistor through the fourth via V4, and may also be electrically connected to the first connection electrode 401 through the fifty-second via V52. The first connection electrode 401 may be electrically connected to the first data line DL1 through the fifty-third via V53. The sixteenth connection electrode 706 may be electrically connected to the gate 311 of the first transistor through the fifty-first via V51, may also be electrically connected to the fifth active layer 350 of the fifth transistor through the thirteenth via V13, may also be electrically connected to the first capacitor plate 381 of the storage capacitor through the ninety-first via V91, and may also be electrically connected to the second connection electrode 402 through the fifty-seventh via V57. The seventeenth connection electrode 707 may be electrically connected to the fifth active layer 350 of the fifth transistor through the fourteenth via V14, may also be electrically connected to the sixth active layer 360 of the sixth transistor through the sixteenth via V16, and may also be electrically connected to the third connection electrode 403 through the sixtieth via V60. The third connection electrode 403 may be electrically connected to the initial signal line INIT through two fifty-ninth vias V59 arranged vertically, and may also be electrically connected to the thirty-seventh connection electrode 727 through the sixty-first via V61.

In some examples, as shown in FIGS. 6A to 6E, the eighteenth connection electrode 708 may be electrically connected to the seventh active layer 470 of the seventh transistor of the second pixel circuit through three seventeenth vias V17 arranged side by side and the nineteenth vias V19 arranged side by side, and may also be electrically connected to the second capacitor plate 382 of the storage capacitor of the second pixel circuit through two sixty-fourth vias V64 arranged side by side, and may also be electrically connected to the first power connection line 601 through the two seventy-eighth vias V78 arranged side by side. The eighteenth connection electrode 708 and the third capacitor plate 483 of the second pixel circuit may be of an integrated structure. The eighteenth connection electrode 708 and the eleventh connection electrode 701 may be of an integrated structure. The nineteenth connection electrode 709 may be electrically connected to the seventh active layer 470 through three eighteenth vias V18 arranged side by side, and may also be electrically connected to the first active layer 410 through two twentieth vias V20 arranged side by side, and may also be electrically connected to the second active layer 420 through the twenty-third via V23. The twentieth connection electrode 710 may be electrically connected to the fourth active layer 440 through three twenty-fourth vias V24 arranged side by side and three twenty-sixth vias V26 arranged side by side, and may also be electrically connected to the sixth active layer 460 through the thirtieth via V30. The twenty-first connection electrode 711 may be electrically connected to the first active layer 410 through two twenty-first vias V21 arranged side by side, and may also be electrically connected to the fourth active layer 440 through three twenty-fifth vias V25 arranged side by side, and may also be electrically connected to the third active layer 430 through the twenty-seventh via V27. The twenty-second connection electrode 712 may be electrically connected to the second active layer 420 through the twenty-second via V22, and may also be electrically connected to the fourth connection electrode 404 through the sixty-seventh via V67. The fourth connection electrode 404 may be electrically connected to the data line DL2 through the sixty-sixth via V66. The twenty-third connection electrode 713 may be electrically connected to the gate 411 of the first transistor through the sixty-first via V61, and may also be electrically connected to the fifth active layer 450 of the fifth transistor through the twenty-eighth via V28, and may also be electrically connected to the fifth connection electrode 405 through the sixty-five via V65, and may also be electrically connected to the first capacitor plate 481 of the storage capacitor through the ninety-second via V92. The twenty-fourth connection electrode 714 may be electrically connected to the fifth active layer 450 through the twenty-ninth via V29, may also be electrically connected to the sixth active layer 460 through the thirty-first via V31, and may also be electrically connected to the sixth connection electrode 406 through the two sixty-ninth vias V69 arranged side by side.

In some examples, as shown in FIGS. 6A to 6E, the twenty-fifth connection electrode 715 may be electrically connected to the seventh active layer 570 of the third pixel circuit through three thirty-second vias V32 arranged side by side and three thirty-fourth vias V34 arranged side by side, and may also be electrically connected to the second capacitor plate 582 of the storage capacitor through two seventy-second vias V72 arranged side by side. The twenty-fifth connection electrode 715 and the third capacitor plate 583 may be of an integrated structure. The twenty-sixth connection electrode 716 may be electrically connected to the seventh active layer 570 through three thirty-third vias V33 arranged side by side, and may also be electrically connected to the first active layer 510 through two thirty-seventh vias V37 arranged side by side, and may also be electrically connected to the second active layer 520 through the thirty-sixth via V36. The twenty-seventh connection electrode 717 may be electrically connected to the first active layer 510 through two thirty-eighth vias V38 arranged side by side, and may also be electrically connected to the fourth active layer 540 through three fortieth vias V40 arranged side by side, and may also be electrically connected to the third active layer 530 through the forty-second via V42. The twenty-eighth connection electrode 718 may be electrically connected to the fourth active layer 540 through three thirty-ninth vias V39 arranged side by side and three forty-first vias V41 arranged side by side, and may also be electrically connected to the sixth active layer 560 through the forty-fifth via V45. The twenty-ninth connection electrode 719 may be electrically connected to the second active layer 520 through the thirty-fifth via V35, and may also be electrically connected to the seventh connection electrode 407 through the seventy-fifth via V75. The seventh connection electrode 407 may be electrically connected to the data line DL3 through the seventy-sixth via V76. The thirtieth connection electrode 720 may be electrically connected to the gate 511 of the first transistor through the seventy-fourth via V74, and may also be electrically connected to the fifth active layer 550 through the forty-third via V43, and may also be electrically connected to the eighth connection electrode 408 through the seventy-third via V73, and may also be electrically connected to the first capacitor plate 581 through the ninety-third via V93. The thirty-first connection electrode 721 may be electrically connected to the sixth connection electrode 406 through two seventy-first vias V71 arranged side by side, and may also be electrically connected to the fifth active layer 550 through the forty-fourth via V44, and may also be electrically connected to the sixth active layer 560 through the forty-sixth via V46.

In some examples, as shown in FIGS. 6A to 6E, the thirty-second connection electrode 722 may be electrically connected to the first power connection line 601 through two seventy-seventh vias V77 arranged side by side. The thirty-third connection electrode 723 may be electrically connected to the second power connection line 602 through the two eightieth vias V80 arranged side by side. The thirty-fourth connection electrode 724 may be electrically connected to the gate 341 of the fourth transistor of the first pixel circuit through the fifty-fourth via V54, and may also be electrically connected to the light emitting control line EML(n) through the seventy-ninth via V79, and may also be electrically connected to the gate 341 of the fourth transistor of the second pixel circuit through the sixty-eighth via V68. The light emitting control line EML(n) and the gate 571 of the seventh transistor and the gate 541 of the fourth transistor of the third pixel circuit may be of an integrated structure. The thirty-fifth connection electrode 725 may be electrically connected to the gate 331 of the third transistor of the first pixel circuit through the fifty-fifth via V55, and may also be electrically connected to the first scan line SL1(n) through the eighty-first via V81, and may also be electrically connected to the gate 431 of the third transistor of the second pixel circuit through the sixty-second via V62. The first scan line SL1(n) and the gate 521 of the second transistor and the gate 531 of the third transistor of the third pixel circuit may be of an integrated structure. The thirty-sixth connection electrode 726 may be electrically connected to the gate 361 of the sixth transistor of the first pixel circuit through the fifty-sixth via V56, and may also be electrically connected to the second scan line SL2(n) through the eighty-second via V82, and may also be electrically connected to the gate 461 of the sixth transistor of the second pixel circuit through the sixty-third via V63. The second scan line SL2(n) and the gate 551 of the fifth transistor and the gate 561 of the sixth transistor of the third pixel circuit may be of an integrated structure. The thirty-seventh connection electrode 727 may be electrically connected to the sixth connection electrode 406 through the seventieth via V70. The initial signal may be transmitted through the initial signal line INIT, the third connection electrode 403, the thirty-seventh connection electrode 727, the sixth connection electrode 406, and the thirty-first connection electrode 721.

In the present disclosure, side by side arrangement means arrangement in the first direction X, and vertical arrangement means arrangement in the second direction Y.

(7) Forming a fourth insulating layer and a fifth insulating layer. In some examples, the fourth insulating film is deposited on the substrate on which the aforementioned structures are formed, and subsequently, the fifth insulating film is coated, and the fifth insulating film and the fourth insulating film are patterned by a patterning process to form the fifth insulating layer and the fourth insulating layer.

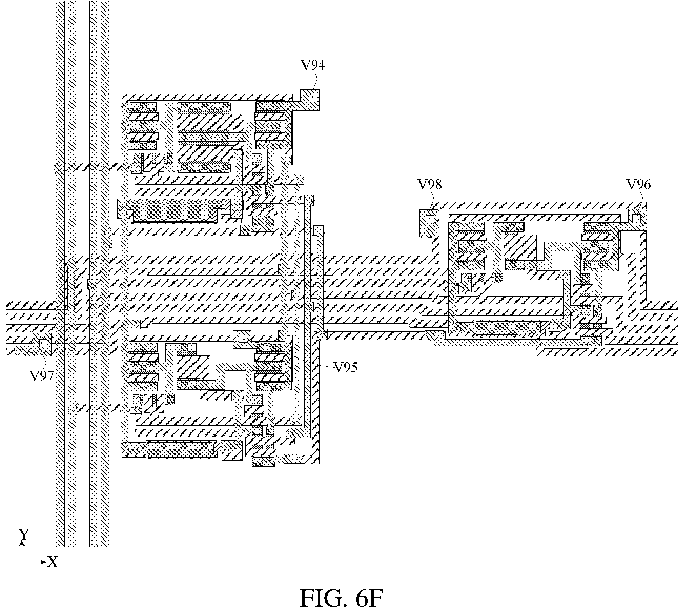

FIG. 6F is a schematic diagram of a fifth insulating layer of a repeating unit according to at least one embodiment of the present disclosure. In some examples, as shown in FIG. 6F, the fifth insulating layer of the non-transmissive region of the repeating unit is opened with a plurality of vias, which may include, for example: the ninety-fourth via V94 to ninety-eighth via V98 that expose the surface of the third conductive layer. The ninety-fourth via V94 may expose the surface of the fourteenth connection electrode 704. The ninety-fifth via V95 may expose the surface of the twentieth connection electrode 710. The ninety-sixth via V96 may expose the surface of the twenty-eighth connection electrode 718. The ninety-seventh via V97 may expose the surface of the thirty-second connection electrode 722. The ninety-eighth via V98 may expose the surface of the thirty-third connection electrode 723.

(8) Forming a fourth conductive layer. In some examples, a fourth conductive film is deposited on the substrate on which the aforementioned structures are formed, and the fourth conductive film is patterned by a patterning process to form the fourth conductive layer in the non-transmissive region.

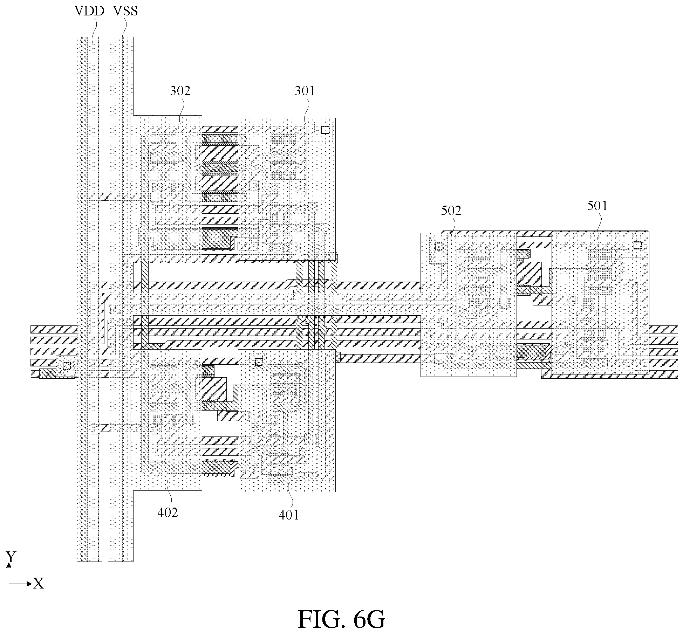

FIG. 6G is a schematic diagram of a fourth conductive layer of a repeating unit according to at least one embodiment of the present disclosure. In some examples, as shown in FIG. 6G, the fourth conductive layer of the non-transmissive region of the repeating unit may include at least: a first power supply line VDD, a second power supply line VSS, a first conductive part 301, a second conductive part 302, a third conductive part 401, a fourth conductive part 402, a fifth conductive part 501, and a sixth conductive part 502. The second power supply line VSS and the first power supply line VDD may extend in the second direction Y. The first power supply line VDD may be located on a side of the second power supply line VSS away from the first pixel circuit and the second pixel circuit in the first direction X. The second power supply line VSS, the second conductive part 302, the fourth conductive part 402, and the sixth conductive part 502 may be of an integrated structure. In this example, by providing the second power supply line VSS, the second conductive part 302, the fourth conductive part 402, and the sixth conductive part 502 as an integrated structure, the area of the non-transmissive region can be reduced, thereby increasing the area of the transmissive region.

In some examples, as shown in FIG. 6G and FIG. 6E, the orthographic projection of the first power supply line VDD on the substrate may cover the orthographic projection of the data lines DL1 and DL2 on the substrate, and the orthographic projection of the second power supply line VSS on the substrate may cover the orthographic projection of the data line DL3 and the initial signal line INIT on the substrate.

In some examples, as shown in FIGS. 6E to 6G, the first conductive part 301 may be electrically connected to the fourteenth connection electrode 704 through the ninety-fourth via V94 to achieve an electrical connection to the first pixel circuit. The third conductive part 401 may be electrically connected to the twentieth connection electrode 710 through the ninety-fifth via V95 to achieve an electrical connection to the second pixel circuit. The fifth conductive part 501 may be electrically connected to the twenty-eighth connection electrode 718 through the ninety-sixth via V96 to achieve an electrical connection to the third pixel circuit. The sixth conductive part 502 may be electrically connected to the thirty-third connection electrode 723 through the ninety-eighth via V98 to achieve an electrical connection to the second power connection line 602. The second power supply line VSS may be electrically connected to the second power connection line 602 through the sixth conductive part 502 and the thirty-third connection electrode 723, thereby realizing a mesh transmission route of the second voltage signal. The first power supply line VDD may be electrically connected to the thirty-second connection electrode 722 through the ninety-seventh via V97 to achieve an electrical connection to the first power connection line 601. The first power supply line VDD may be electrically connected to the first power connection line 601 through the thirty-second connection electrode 722 to achieve a mesh transmission route for the first voltage signal. In this example, the resistances of the first power supply line and the second power supply line can be reduced by realizing a mesh connection of the second power supply line and a mesh connection of the first power supply line.

(9) Forming a sixth insulating layer and a seventh insulating layer. In some examples, the sixth insulating film is deposited on the substrate on which the aforementioned structures are formed, and subsequently, the seventh insulating film is coated, and the seventh insulating film and the sixth insulating film are patterned by a patterning process to form the seventh insulating layer and the sixth insulating layer.

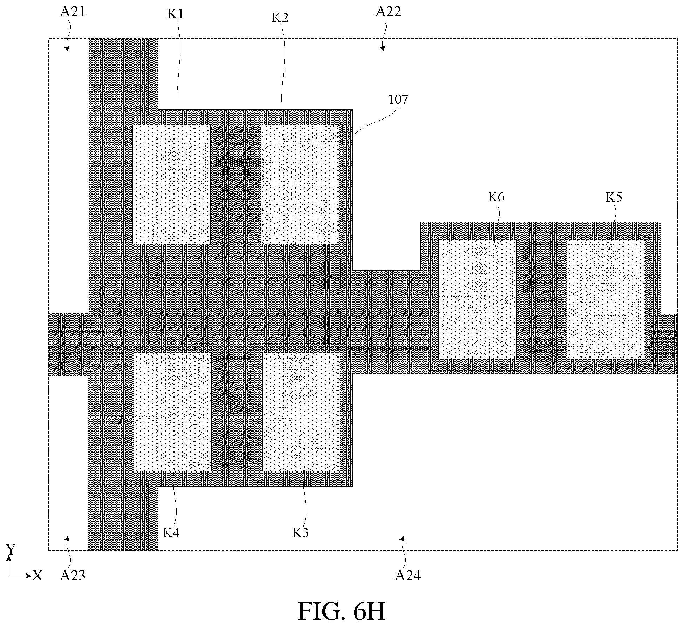

FIG. 6H is a schematic diagram of a seventh insulating layer of a repeating unit according to at least one embodiment of the present disclosure. In some examples, as shown in FIG. 6H, the seventh insulating layer 107 of the non-transmissive region of the repeating unit may be opened with a plurality of openings, which may include, for example, a first opening K1 to a sixth opening K6 that expose the surface of the fourth conductive layer. The first opening K1 may expose the surface of the second conductive part 302, and a region of the second conductive part 302 exposed by the first opening K1 may serve as a cathode pad, which is subsequently bonded to the second electrode of the first light emitting element. The second opening K2 may expose the surface of the first conductive part 301, and a region of the first conductive part 301 exposed by the second opening K2 may be used as an anode pad, which is subsequently bonded to the first electrode of the first light emitting element. The third opening K3 can expose the surface of the third conductive part 401, and a region of the third conductive part 401 exposed by the third opening K3 may be used as an anode pad, which are subsequently bonded to the first electrode of the second light emitting element. The fourth opening K4 may expose the surface of the fourth conductive part 402, and a region of the fourth conductive part 402 exposed by the fourth opening K4 may serve as a cathode pad, which is subsequently bonded to the second electrode of the second light emitting element. The fifth opening K5 may expose the surface of the fifth conductive part 501, and a region of the fifth conductive part 501 exposed by the fifth opening K5 may serve as an anode pad, which is subsequently bonded to the first electrode of the third light emitting element. The sixth opening K6 may expose the surface of the sixth conductive part 502, and a region of the sixth conductive part 502 exposed by the sixth opening K6 may serve as a cathode pad, which is subsequently bonded to the second electrode of the third light emitting element. For example, the orthographic projection of the first opening K1 and the fourth opening K4 on the substrate may overlap with the orthographic projection of the second power supply line VSS on the substrate. A region of the non-transmissive region other than the first opening K1 to the sixth opening K6 may be covered by the seventh insulating layer and the sixth insulating layer. The seventh insulating layer in transmissive sub-region (e.g., the first transmissive sub-region A21 to the fourth transmissive sub-region A24) other than the non-transmissive region of the repeating unit may be removed, and the sixth insulating layer may be retained. However, this embodiment is not limited thereto.

So far, the circuit structure layer is prepared and formed in the non-transmissive region. After this process, the transmissive region may include only: a substrate, and a first insulating layer to a sixth insulating layer provided sequentially on the substrate.

In some examples, the first insulating layer to the fourth insulating layer and the sixth insulating layer may use any one or more or any combination of silicon nitride (SiNx), silicon oxide (SiOx), silicon nitride oxide (SiON), and may be a single layer, multiple layers, or a composite layer. The fifth insulating layer and the seventh insulating layer may use an organic insulating material, for example, a resin material. The first to fourth conductive layers may use metal materials, for example, any one or more of aluminum (Al), molybdenum (Mo) and titanium (Ti), or alloys of the above metals, such as aluminum-neodymium (AlNd) or molybdenum-niobium (MoNb), and may be a single-layer structure, or a multi-layer composite structure. However, this embodiment is not limited thereto.

(10) Forming a light emitting structure layer. In some examples, a bonding material (such as solder paste) is added into the first opening K1 to the sixth opening K6 using a glue dispenser, and the connection between the light emitting element and the substrate is completed through the die bonding process. For example, the first electrode of the first light emitting element is bonded to the anode pad through the bonding material of the second opening K2, and the second electrode of the first light emitting element is bonded to the cathode pad through the bonding material in the first opening K1. Similarly, the bonding connection of the second light emitting element and the third light emitting element can be realized.

The structure of the film layer in the transmissive region has not changed after this process.

(11) Forming a cover layer. In some examples, a covering film is coated on the substrate on which the aforementioned structures are formed, to form the cover layer. The cover layer may cover the repeating unit. After this process, the transmissive region may include: a substrate, and a first insulating layer to a sixth insulating layer provided sequentially on the substrate, and the cover layer. By providing the cover layer, the light emitting structure layer may be encapsulated and protected, and the transmittance of the emitted light is not reduced.

The structure of the transparent display panel of the exemplary embodiment and the preparation process thereof are described only as an example. In some exemplary implementations, a corresponding structure may be changed and a patterning process may be increased or decreased according to actual needs. For example, the data lines DL1 to DL2 and the initial signal line INIT may all be covered by the first power supply line VDD, alternatively, may all be covered by the second power supply line VSS. As another example, the first power supply line VDD may be located on the third conductive layer. As another example, the first power supply line VDD may cover three data lines, and the second power supply line VDD may cover the initial signal line. As another example, the first power supply line VDD may cover the initial signal line, and the second power supply line VSS may cover the three data lines.

The preparation process of this exemplary embodiment may be implemented by using the existing mature preparation equipment, which has slight improvement on the existing processes, and can be well compatible with the existing preparation processes. The processes are easy to realize and implement, the production efficiency is high, the production cost is low, and the yield is high.

In this example, a plurality of first signal lines included in a set of first signal lines 11 within the repeating unit may include: a first power connection line 601, a second power connection line 602, a light emitting control line EML(n), a first scan line SL1(n), and a second scan line SL2(n). The light emitting control line EML(n), the first scan line SL1(n), and the second scan line SL2(n) may be electrically connected to the pixel circuits of three sub-pixels within the pixel unit of the same row. A plurality of third signal lines included in a set of second signal lines 12 may include: data lines DL1 to DL3 and an initial signal line INIT, and a plurality of fourth signal lines included in the set of second signal lines may include: a first power supply line VDD and a second power supply line VSS. The orthographic projection of the first power supply line VDD on the substrate may cover the orthographic projection of the data lines DL1 and DL2 on the substrate, and the orthographic projection of the second power supply line VSS on the substrate may cover the orthographic projection of the data line DL3 and the initial signal line INIT on the substrate.

In some examples, the line widths of the data lines may be determined based on the data load and a metal wire process preparation capability, and the line widths of the first power supply line VDD and the second power supply line VSS may be determined by the voltage drop and the metal wire process preparation capability. In some examples, the sizes (i.e., line widths) of data lines DL1 to DL3 and the initial signal line INIT in the first direction X may be approximately the same. The size of the first power supply line VDD in the first direction X may be greater than twice the size of the data line DL1 in the first direction X. The size of the second power supply line VSS in the first direction X may be greater than twice the size of the data line DL1 in the first direction X. For example, the orthographic projection of the two data lines DL1 on the substrate falls within the orthographic projection of one second power supply line VSS on the substrate, and the size of the second power supply line VSS in the first direction X is approximately equal to the sum of the sizes of the two data lines DL1 in the first direction X and the spacing of the two adjacent data lines DL1 in the first direction X.

In some examples, the spacing between adjacent data lines located in the third conductive layer or between a data line and an initial signal line adjacent to the data line may be about 3 microns, and the spacing between the first power supply line VDD and the second power supply line VSS located in the fourth conductive layer may be about 5 microns.

In this example, Aggregation design is adopted for a plurality of first signal lines, and the aggregation design is adopted for a plurality of third signal lines and fourth signal lines, the first power supply line and the second power supply line are arranged to extend in the second direction Y, and a superimposition design may be adopted for the first power supply line and the second power supply line, and the data line and the initial signal line extending in the second direction Y, which can achieve the largest area of a transmissive region of a minimum unit surrounded by the non-transmissive region, reduce diffraction and improve the display quality of the transparent display panel.

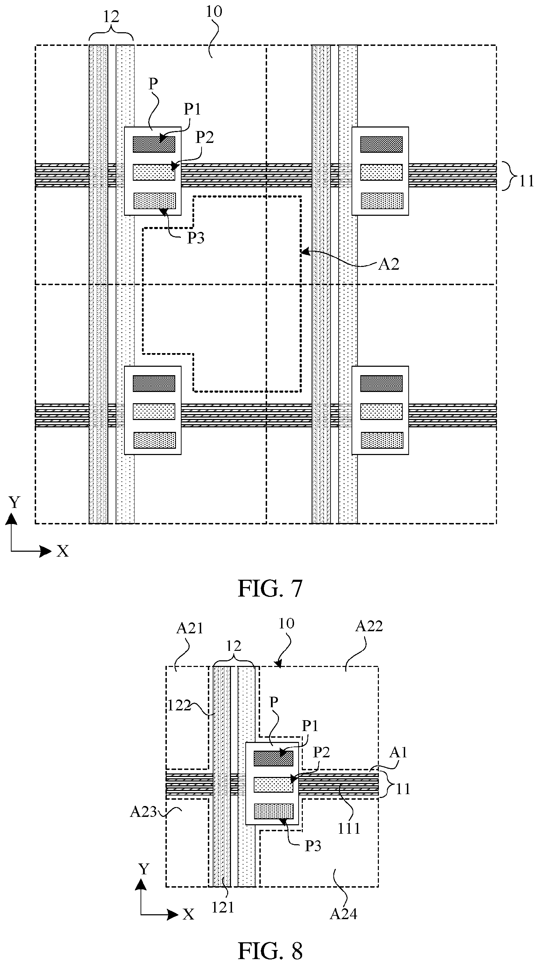

FIG. 7 is another partial schematic view of a transparent display panel according to at least one embodiment of the present disclosure. FIG. 8 is a schematic view of a repeating unit of a transparent display panel according to at least one embodiment of the present disclosure. FIG. 7 is formed by the four repeating units shown in FIG. 8 arranged in a 2 x 2 array.

In some examples, as shown in FIGS. 7 and 8, the repeating unit 10 is substantially quadrilateral, and may be a rectangular, for example. The transmissive sub-regions of four repeating units 10 arranged in a 2×2 array may be connected to form a transmissive region A2. The transmissive region A2 may be surrounded by non-transmissive regions A1. The non-transmissive region A1 of the repeating unit 10 may include a pixel unit P, and a set of first traces 11 and a set of second traces 12 electrically connected to the pixel unit P. The first sub-pixel P1, the second sub-pixel P2 and the third sub-pixel P3 of the pixel unit P may be arranged sequentially in the second direction Y. A set of first traces 11 may include a plurality of first signal lines 111 extending in a first direction X. The plurality of first signal lines 111 may include: a first scan line, a second scan line, a light emitting control line, a first power connection line, and a second power connection line electrically connected to the pixel unit P. A set of second traces 12 may include a plurality of third signal lines 121 and a plurality of fourth signal lines 122 extending in a second direction Y. The plurality of fourth signal lines 122 and the plurality of third signal lines 121 may be located in different film layers. The plurality of third signal lines 121 may include at least: three data lines electrically connected to the pixel unit P. The plurality of fourth signal lines 122 may include a first power supply line and a second power supply line. For example, the orthographic projection of the fourth signal line 122, on the substrate overlaps with the orthographic projection of the pixel unit P on the substrate, and the fourth signal line 122 may be a second power supply line, and the other fourth signal line 122 may be a first power supply line. In some examples, the initial signal line may extend in a second direction Y, such as belonging to a third signal line; alternatively, the initial signal line may extend in a first direction X, such as belonging to a first signal line. However, this embodiment is not limited thereto. In some examples, the first power supply line may be electrically connected to the first power connection line, and the second power supply line may be electrically connected to the second power connection line, thereby realizing mesh transmission routes for the first voltage signal and the second voltage signal.

In some examples, as shown in FIGS. 7 and 8, the orthographic projection of a fourth signal line 122 (e.g., a first power supply line) located in the fourth conductive layer on the substrate may cover the orthographic projection of a plurality (e.g., three or four) of third signal lines 121 located in the third conductive layer on the substrate. The orthographic projection of another fourth signal line 122 (e.g., a second power supply line) located in the fourth conductive layer on the substrate may not overlap with the orthographic projection of the third signal line 121 on the substrate. A plurality of third signal lines 121 may be electrically connected to a plurality of pixel circuits of the pixel unit P via connection electrodes.

The transparent display panel provided by this example adopts an aggregation design for a plurality of first signal lines, an aggregation design for a plurality of third signal lines and fourth signal lines, and a superimposition design for a fourth signal line and a plurality of third signal lines, so that the area of a transmissive region of a minimum unit surrounded by the non-transmissive region can be maximized, thereby reducing diffraction and improving the display quality of the transparent display panel. The rest of the structure of the transparent display panel according to the embodiment may be referred to descriptions of the aforementioned embodiments, and will not be repeated here.

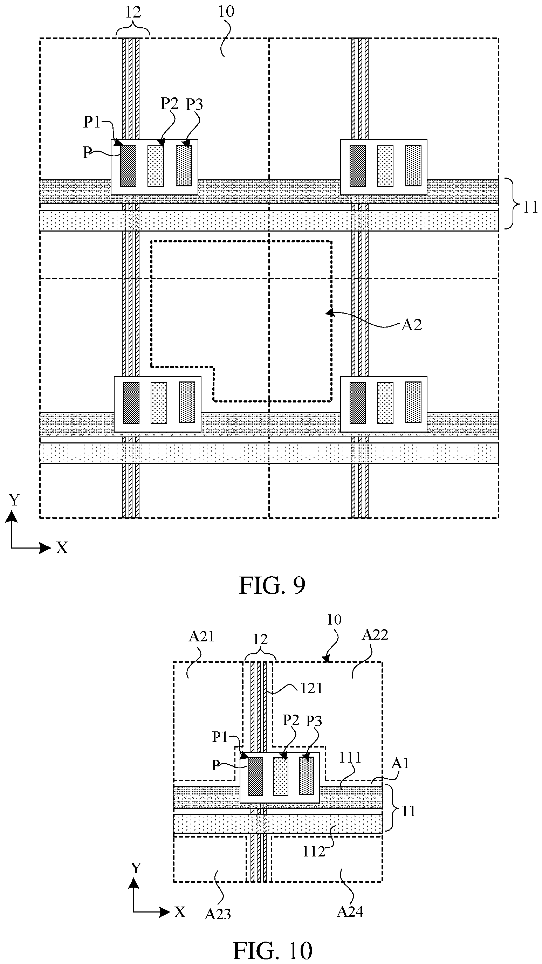

FIG. 9 is another partial schematic view of a transparent display panel according to at least one embodiment of the present disclosure. FIG. 10A is a schematic view of a repeating unit of a transparent display panel according to at least one embodiment of the present disclosure. FIG. 9 is formed by the four repeating units shown in FIG. 10 arranged in a 2 x 2 array.

In some examples, as shown in FIGS. 9 and 10, the repeating unit 10 is substantially quadrilateral, and may be a rectangular, for example. The transmissive sub-regions of the four repeating units 10 arranged in a 2×2 array may be connected to form a transmissive region A2. The transmissive region A2 may be surrounded by non-transmissive regions A1. The non-transmissive region A1 of the repeating unit 10 may include a pixel unit P, and a set of first traces 11 and a set of second traces 12 electrically connected to the pixel unit P. The first sub-pixel P1, the second sub-pixel P2 and the third sub-pixel P3 of the pixel unit P may be arranged sequentially in the first direction X. The set of first traces 11 may include: a plurality of first signal lines 111 and a plurality of second signal lines 112 extending in the first direction X. The plurality of first signal lines 111 may be arranged sequentially in the second direction Y and be of a structure of a same layer, such as located in the first conductive layer. For example, the plurality of first signal lines 111 may include: a first scan line, a second scan line, a light emitting control line, and an initial signal line electrically connected to the pixel unit P. The plurality of second signal lines 112 may be of a structure of a same layer, such as located in the fourth conductive layer. For example, the plurality of second signal lines 112 may include: a first power supply line and a second power supply line. For example, the orthographic projection of the second signal line 112 on the substrate overlaps with the orthographic projection of the pixel unit P on the substrate, and the second signal line 112 may be a second power supply line, and the other second signal line 112 may be a first power supply line. The set of second traces 12 may include: a plurality of third signal lines 121 extending in a second direction Y. The plurality of third signal lines 121 may be sequentially arranged in a first direction X and be of a structure of a same layer, such as located in a third conductive layer. In some examples, the plurality of third signal lines may also include: a first power connection line and a second power connection line, the first power connection line may be electrically connected to the first power supply line, and the second power connection line may be electrically connected to the second power supply line, thereby realizing mesh transmission routes for the first voltage signal and the second voltage signal.

In some examples, as shown in FIGS. 9 and 10, the orthographic projection of a second signal line 112 (e.g., a second power supply line) on the substrate may cover the orthographic projection of a plurality of first signal lines 111 on the substrate. The orthographic projection of another second signal line 112 (e.g., the first power supply line) on the substrate may not overlap with the orthographic projection of the first signal line 111 on the substrate. In some examples, the size (i.e., line width) of at least one second signal line 112 in the second direction Y may be larger than the size of at least two first signal lines 111 in the second direction Y. However, this embodiment is not limited thereto. In other examples, the orthographic projection of two second signal lines on the substrate may both cover the orthographic projection of a plurality of first signal lines on the substrate.

The transparent display panel provided in this example adopts an aggregation design for a plurality of first signal lines, an aggregation design for a plurality of third signal lines and fourth signal lines, and a superimposition design for at least one second signal line and a plurality of first signal lines, so that the area of the transmissive region of a minimum unit surrounded by the non-transmissive region can be maximized, thereby reducing diffraction and improving the display quality of the transparent display panel. The rest of the structure of the transparent display panel according to the embodiment may be referred to descriptions of the aforementioned embodiments, and will not be repeated here.

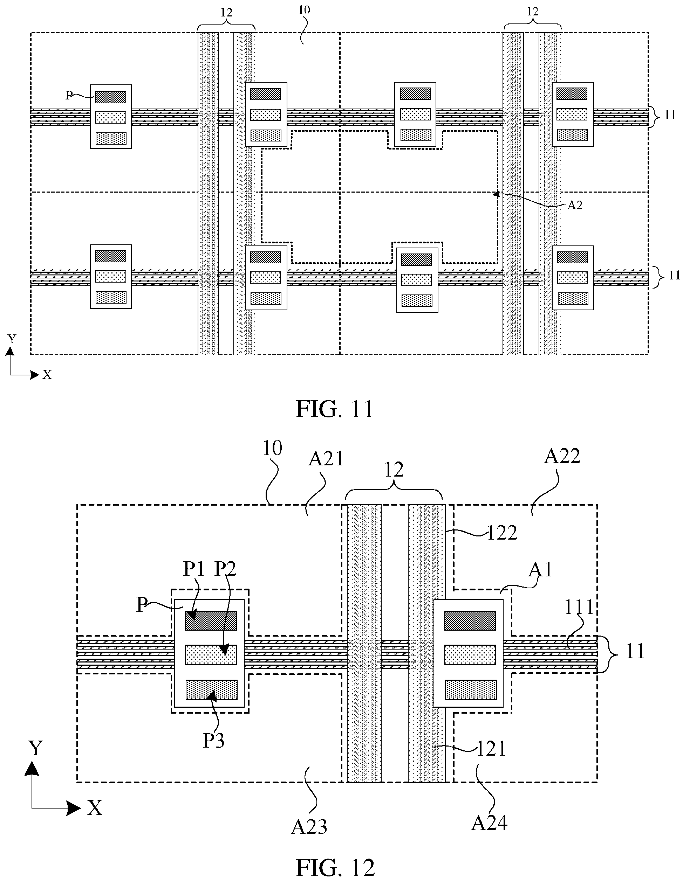

FIG. 11 is another partial schematic view of a transparent display panel according to at least one embodiment of the present disclosure. FIG. 12 is a schematic view of a repeating unit of a transparent display panel according to at least one embodiment of the present disclosure. FIG. 12 is formed by the four repeating units shown in FIG. 11 arranged in a 2 x 2 array.

In some examples, as shown in FIGS. 11 and 12, a repeating unit 10 may include: two pixel units P, a set of first traces 11, and a set of second traces 12. The two pixel units P may be arranged sequentially along a first direction X. Each pixel unit P may include a first sub-pixel P1, a second sub-pixel P2, and a third sub-pixel P3 arranged sequentially in a second direction Y. The set of first traces 11 may include a plurality of first signal lines 111 (which may include, for example, a first scan line, a second scan line, a light emitting control line, an initial signal line, a first power connection line, and a second power connection line electrically connected to said two pixel units P) extending in the first direction X. The plurality of first signal lines 111 may be of a structure of a same layer, e.g. located in the first conductive layer. The set of second traces 12 may include: a plurality of third signal lines 121 and a plurality of fourth signal lines 122 extending in the second direction Y. The plurality of third signal lines 121 may be sequentially arranged in the first direction X and are of a structure of a same layer, such as located in the third conductive layer. The plurality of third signal lines 121 may include: a plurality of data lines electrically connected to the two pixel units P. The plurality of fourth signal lines 122 may be located in the fourth conductive layer, and may include, for example, a first power supply line and a second power supply line. The orthographic projection of the second power supply line on the substrate may overlap with the orthographic projection of one of the pixel units on the substrate.

In some examples, as shown in FIGS. 11 and 12, the orthographic projection of a fourth signal line 122 (e.g., a first power supply line) on the substrate may cover the orthographic projection of a plurality of third signal lines (e.g., a plurality of data lines electrically connected to the pixel unit P on the left side) on the substrate, and the orthographic projection of another fourth signal line 122 (e.g., a second power supply line) on the substrate may cover the orthographic projection of a plurality of third signal lines ( e.g., a plurality of data lines electrically connected to the pixel unit P on the right side) on the substrate. However, this embodiment is not limited thereto. In other examples, the orthographic projection of one of the fourth signal lines on the substrate may cover the orthographic projection of a plurality of data lines electrically connected to two pixel units on the substrate, and the orthographic projection of another fourth signal lines on the substrate may not overlap with the orthographic projection of the data lines on the substrate.

In some examples, as shown in FIGS. 11 and 12, a pixel unit P that is relatively far from a set of second traces 12 may be electrically connected to the set of second traces (e.g., including: data lines) 12 by a connection line (not shown) extending in the first direction X.

This example adopts an aggregation design for a plurality of data lines electrically connected to two adjacent pixel units of a same row, an aggregation design for a first power supply line and a second power supply line electrically connected to two adjacent pixel units of a same row, and a superimposition design for at least one fourth signal line and a plurality of third signal lines, so that the area of a transmissive region of a minimum unit surrounded by the non-transmissive region can be maximized, thereby reducing diffraction and improving the display quality of the transparent display panel. The rest of the structure of the transparent display panel according to the embodiment may be referred to descriptions of the aforementioned embodiments, and will not be repeated here.

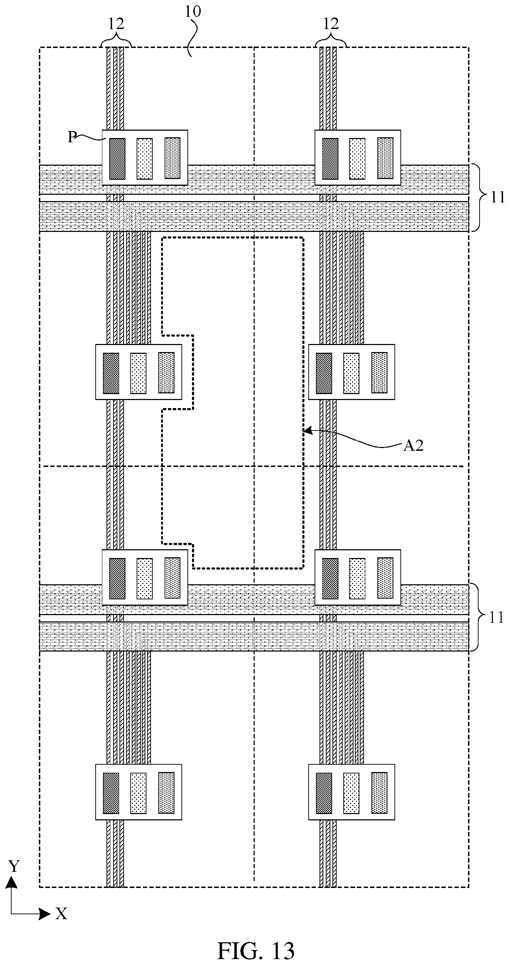

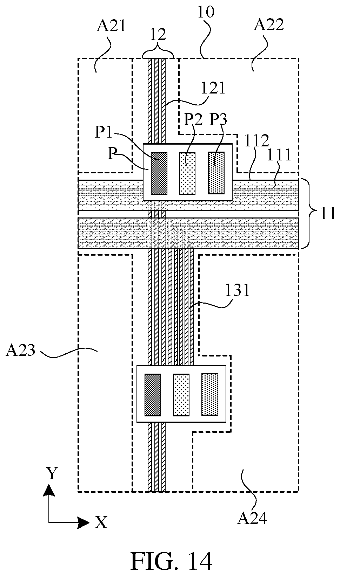

FIG. 13 is another partial schematic view of a transparent display panel according to at least one embodiment of the present disclosure. FIG. 14 is a schematic view of a repeating unit of a transparent display panel according to at least one embodiment of the present disclosure. FIG. 14 is formed by the four repeating units shown in FIG. 13 arranged in a 2 × 2 array.

In some examples, as shown in FIGS. 13 and 14, a repeating unit 10 may include: two pixel units P, a set of first traces 11, and a set of second traces 12. The two pixel units P may be arranged sequentially along a second direction Y. Each pixel unit P may include a first sub-pixel P1, a second sub-pixel P2 and a third sub-pixel P3 arranged sequentially in a first direction X. The set of first traces 11 may include a plurality of first signal lines 111 (which may include, for example, a first scan line, a second scan line, a light emitting control line and an initial signal line electrically connected to said two pixel units P) extending in a first direction X, and a plurality of second signal lines 112 (which includes, for example, a first power supply line and a second power supply line). The orthographic projection of a second signal line 112 overlaps with the orthographic projection of one pixel unit P in the repetition unit 10, and the second signal line 112 may be a second power supply line, and the other second signal line 112 may be a first power supply line. The first power supply line and the second power supply line may be structures of a same layer, for example, they may be located in the fourth conductive layer. Another pixel unit P in the repetition unit 10 may be electrically connected to a plurality of first signal lines 111 (including, for example, a first scan line, a second scan line, and a light emitting control line, etc.) via a plurality of first connection lines 131 extending in the second direction Y. The plurality of first signal lines 111 may be of a structure of a same layer, such as located in the first conductive layer. A plurality of first connection lines 131 may be of a structure of a same layer, such as located in a second conductive layer or a third conductive layer. The orthographic projection of one of the second signal lines 112 (e.g., the second power supply line) on the substrate may cover the orthographic projection of the plurality of first signal lines 111 (e.g., the first signal lines electrically connected to the previous pixel unit P) on the substrate, and the orthographic projection of the other second signal line 112 (e.g., the first power supply line) on the substrate may cover the orthographic projection of the plurality of first signal lines 111 (e.g., the first signal lines electrically connected to the next pixel unit P) on the substrate. The set of second traces 12 may include a plurality of third signal lines 121, and the plurality of third signal lines 121 may be a plurality of data lines electrically connected to two pixel units P. However, this embodiment is not limited thereto. In some other examples, the orthographic projection of one of the second signal lines on the substrate may cover the orthographic projection of a plurality of first signal lines electrically connected to the two pixel units on the substrate, and the orthographic projection of another second signal line on the substrate may not overlap with the orthographic projection of the first signal line on the substrate.

This example adopts an aggregation design for a plurality of data lines electrically connected to two adjacent pixel units of a same column, an aggregation design for a first power supply line and a second power supply line electrically connected to two adjacent pixel units of a same column, and a superimposition design for at least one second signal line and a plurality of first signal lines, so that the area of a transmissive region of a minimum unit surrounded by the non-transmissive region can be maximized, thereby reducing diffraction and improving the display quality of the transparent display panel. The rest of the structure of the transparent display panel according to the embodiment may be referred to descriptions of the aforementioned embodiments, and will not be repeated here.

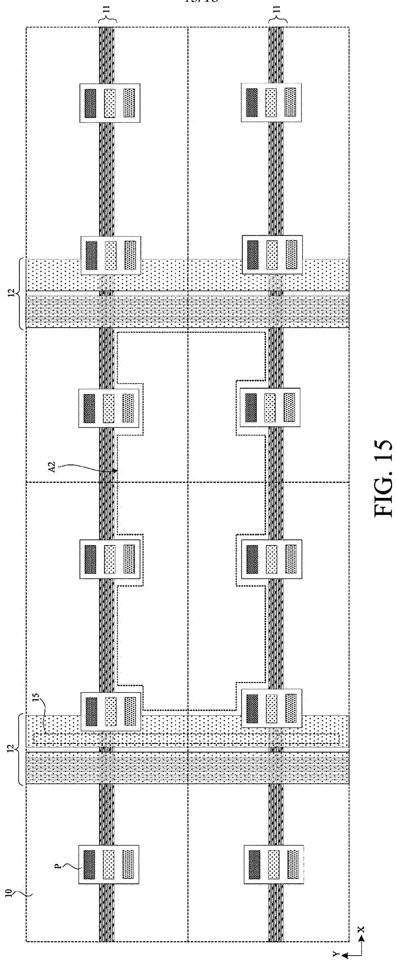

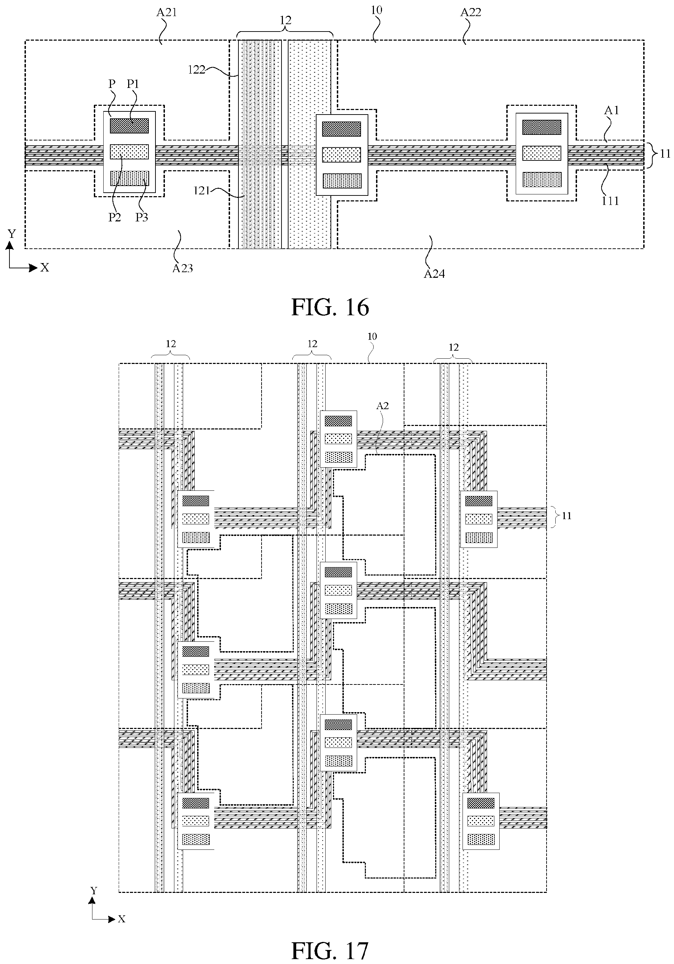

FIG. 15 is another partial schematic view of a transparent display panel according to at least one embodiment of the present disclosure. FIG. 16 is a schematic view of a repeating unit of a transparent display panel according to at least one embodiment of the present disclosure. FIG. 15 is formed by the four repeating units shown in FIG. 16 arranged in a 2 × 2 array.

In some examples, as shown in FIGS. 15 and 16, a repeating unit 10 may include: three pixel units P, a set of first traces 11, and a set of second traces 12. The three pixel units P may be arranged sequentially along a first direction X. Each pixel unit P may include a first sub-pixel P1, a second sub-pixel P2 and a third sub-pixel P3 arranged sequentially in a second direction Y. The set of first traces 11 may include a plurality of first signal lines 111 (e.g., they may include: a first scan line, a second scan line, a light emitting control line, an initial signal line, a first power connection line and a second power connection line electrically connected to the three pixel units P) extending in a first direction X. The plurality of first signal lines 111 may be of a structure of a same layer, such as located in the first conductive layer. A set of second traces 12 may include: a plurality of third signal lines 121 and a plurality of fourth signal lines 122 extending in the second direction Y. The plurality of third signal lines 121 may be sequentially arranged in the first direction X and are of a structure of a same layer, such as located in the third conductive layer. The plurality of third signal lines 121 may include: a plurality of data lines electrically connected to the three pixel units P. A plurality of fourth signal lines 122 may be located in the fourth conductive layer, and may include, for example, a first power supply line and a second power supply line. The orthographic projection of the second power supply line on the substrate may overlap with the orthographic projection of a middle pixel unit P on the substrate. The first power supply line may be located on a side of the second power supply line away from the middle pixel unit P in the first direction X.

In some examples, as shown in FIG. 15 and FIG. 16, the orthographic projection of a fourth signal line 122 (e.g., a first power supply line) on the substrate may cover the orthographic projection of a plurality of third signal lines (e.g., a plurality of data lines electrically connected to the three pixel units P) on the substrate, and the orthographic projection of another fourth signal line 122 (e.g., a second power supply line) on the substrate may not overlap with the orthographic projection of a plurality of third signal lines on the substrate. However, this embodiment is not limited thereto. In some other examples, the orthographic projections of the two fourth signal lines on the substrate may both overlap with the orthographic projection of the plurality of third signal lines on the substrate.

In some examples, as shown in FIG. 15 and FIG. 16, a pixel unit P that is relatively far from a set of second traces 12 may be electrically connected to the set of second traces (e.g., including: data lines) 12 by a connection line (not shown) extending in the first direction X.

In some examples, as shown in FIG. 15, the orthographic projection of one of the fourth signal lines 122 on the substrate may overlap with the orthographic projection of the shift-scan circuit 15 on the substrate. The shift-scan circuit 15 may be configured to provide a first scan signal, a second scan signal, or a light emitting control signal to the pixel circuit. For example, the orthographic projection of a fourth signal line 122 (e.g., a second power supply line) of a repeating unit on the substrate may overlap with the orthographic projection of the shift-scan circuit providing the first scan signal on the substrate, and the orthographic projection of a fourth signal line 122 (e.g., a second power supply line) of another repeating unit on the substrate may overlap with the orthographic projection of the shift-scan circuit providing the light emitting control signal on the substrate. The second power supply line of which the orthographic projection overlaps with the orthographic projection of the shift-scan circuit providing the first scan signal may be adjacent to the second power supply line of which the orthographic projection overlaps with the orthographic projection of the shift-scan circuit providing the light emitting control signal. However, this embodiment is not limited thereto. For example, the two aforementioned second power supply lines may not be adjacent to each other. In other examples, the orthographic projection of the shift-scan circuit for providing the first scan signal and the orthographic projection of the shift-scan circuit for providing the light emitting control signal on the substrate may overlap with the orthogonal projection of the same second power supply line on the substrate, respectively.

In some examples, a shift-scan circuit may include a plurality of cascaded shift-register units, each of which may provide a first scan signal, a second scan signal, or a light emitting control signal to a row of pixel units. For example, a direction of extension of a fourth signal line of which the orthographic projection overlaps with the orthographic projection of a shift-scan circuit may be consistent with a cascade direction of the plurality of shift-register units in the shift-scan circuit. In some examples, a fourth signal line (e.g., a second power supply line) may have an area greater than an area of the orthographic projection of the shift-scan circuit with which overlaps with the orthographic projection of the fourth signal line overlaps. For example, the orthographic projection of a fourth signal line on the substrate may cover the orthographic projection of at least one shift-scan circuit on the substrate.

In some examples, the orthographic projection of a shift-scan circuit on the substrate may overlap with the orthographic projection of a plurality of fourth signal lines on the substrate. For example, the orthographic projection of a fourth signal line on the substrate may overlap with the orthographic projection of at least one shift register unit of the shift-scan circuit on the substrate. A plurality of fourth signal lines of which the orthographic projections overlap with the orthographic projection of the same shift-scan circuit on the substrate, respectively, may be adjacent. However, this embodiment is not limited thereto.

In some examples, the transparent display panel may include two shift-scan circuits, wherein one shift-scan circuit may be used to provide a first scan signal and a second scan signal, and the other shift-scan circuit may be used to provide a light emitting control signal. The orthographic projections of the two shift-scan circuits may each overlap with the orthographic projection of a different fourth signal line on the substrate. For example, the orthographic projection of one shift-scan circuit overlaps with the orthographic projection of one fourth signal line on the substrate. The two fourth signal lines may be as far away from each other as possible to reduce the possibility of interference between the signals. For example, one of the fourth signal lines may be adjacent to the left bezel of the transparent display panel, and the other fourth signal line may be adjacent to the right bezel of the transparent display panel.

This example adopts an aggregation design for a plurality of data lines electrically connected to three adjacent pixel units of a same row, an aggregation design for a first power supply line and second power supply line electrically connected to three adjacent pixel units of a same row, and a superimposition design for at least one fourth signal line and a plurality of third signal lines, so that the area of a transmissive region of a minimum unit surrounded by the non-transmissive region can be maximized, thereby reducing diffraction and improving the display quality of the transparent display panel. Moreover, by providing the shift-scan circuit in the non-transmissive region and using a superimposition design for the shift-scan circuit and the fourth signal line, a narrow bezel or even a bezel-less design can be realized. The rest of the structure of the transparent display panel according to the embodiment may be referred to descriptions of the aforementioned embodiments, and will not be repeated here.

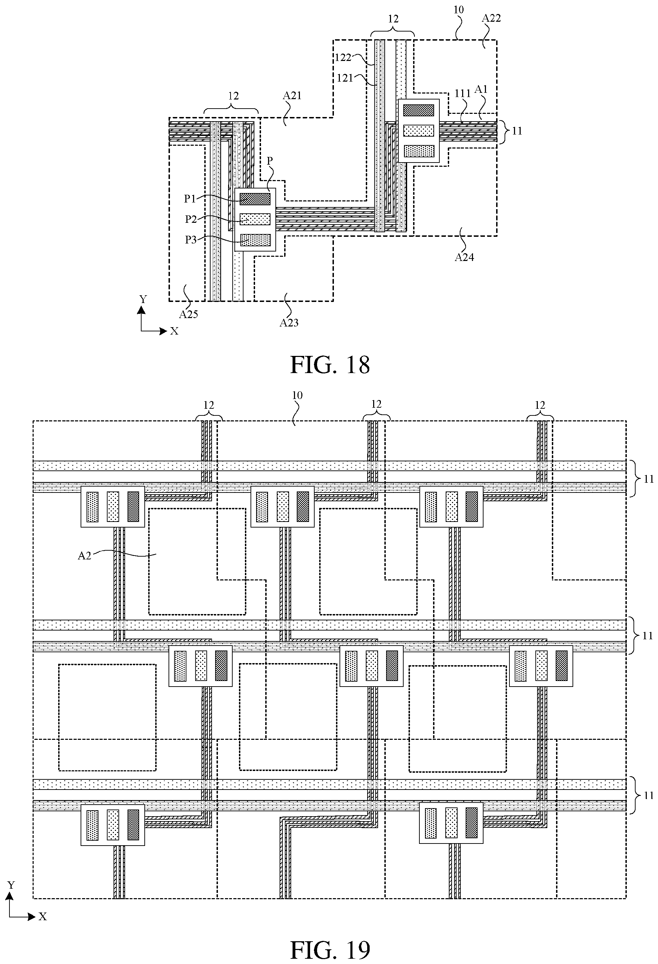

FIG. 17 is another partial schematic view of a transparent display panel according to at least one embodiment of the present disclosure. FIG. 18 is a schematic diagram of a repeating unit of a transparent display panel according to at least one embodiment of the present disclosure. In some examples, as shown in FIG. 17 and FIG. 18, a repeating unit 10 may include: a non-transmissive region A1 and five transmissive sub-regions (e.g., first transmissive sub-region A21 to fifth transmissive sub-region A25). Adjacent transmissive sub-regions are spaced by the non-transmissive regions A1.

In some examples, as shown in FIG. 17 and FIG. 18, the repetition unit 10 may be substantially octagonal. The non-transmissive region A1 of the repetition unit 10 may include: two pixel units P, a set of first traces 11, and two sets of second traces 12. The two pixel units P may be arranged in a first direction X and may be misaligned in the first direction X. A pixel unit P may include a first sub-pixel P1, a second sub-pixel P2 and a third sub-pixel P3 arranged sequentially in a second direction Y. The set of first traces 11 may include a plurality of first signal lines 111 (e.g., they may include: a first scan line, a second scan line, a light emitting control line, an initial signal line, a first power connection line and a second power connection line electrically connected to the two pixel units P). The plurality of first signal lines 111 may be of a structure of a same layer, such as located in the first conductive layer. The plurality of first signal lines 111 may in folding lines in the first direction X. Each first signal line 111 may be formed by sequentially connecting a first line segment extending in the first direction X and a second line segment extending in the second direction Y. Each set of second traces 12 may include: a plurality of third signal lines 121 and a plurality of fourth signal lines 122 extending in the second direction Y. The plurality of third signal lines 121 may be sequentially arranged in the first direction X and are of a structure of a same layer, such as located in the third conductive layer. The plurality of third signal lines 121 of each set of second traces 12 may include: a plurality of data lines electrically connected to a pixel unit P. The plurality of fourth signal lines 122 of each set of second traces 12 may be located in the fourth conductive layer, and may include, for example, a first power supply line and a second power supply line. The orthographic projection of the second power supply line on the substrate may overlap with the orthographic projection of one pixel unit P on the substrate. The first power supply line may be located on a side of the second power supply line away from the pixel unit P in the first direction X.

In some examples, as shown in FIGS. 17 and 18, the orthographic projection of one of the fourth signal lines 122 (e.g., the first power supply line) of each set of second traces 12 on the substrate may cover the orthographic projection of a plurality of third signal lines (e.g., a plurality of data lines electrically connected to a pixel unit P) on the substrate , and the orthographic projection of another fourth signal line 122 (e.g., the second power supply line) on the substrate may not overlap with the orthographic projection of the plurality of third signal lines on the substrate, and the orthographic projection of the fourth signal line 122 (e.g., the second power supply line) on the substrate may overlap with the orthographic projection of the second line segments of the plurality of first signal lines 111 on the substrate . However, this embodiment is not limited thereto. In other examples, the orthographic projection of each fourth signal line on the substrate may each overlap with the orthographic projection of the plurality of third signal lines on the substrate.

This example sets two adjacent pixel units in a same row in a misaligned position, and adopts an aggregation design for a plurality of data lines, first power supply line, and second power supply line electrically connected to pixel units in the same column, and a superimposition design for at least one fourth signal line and a plurality of third signal lines, so that the area of a transmissive region of a minimum unit surrounded by the non-transmissive region can be maximized, thereby reducing diffraction and improving the display quality of the transparent display panel. The rest of the structure of the transparent display panel according to the embodiment may be referred to descriptions of the aforementioned embodiments, and will not be repeated here.

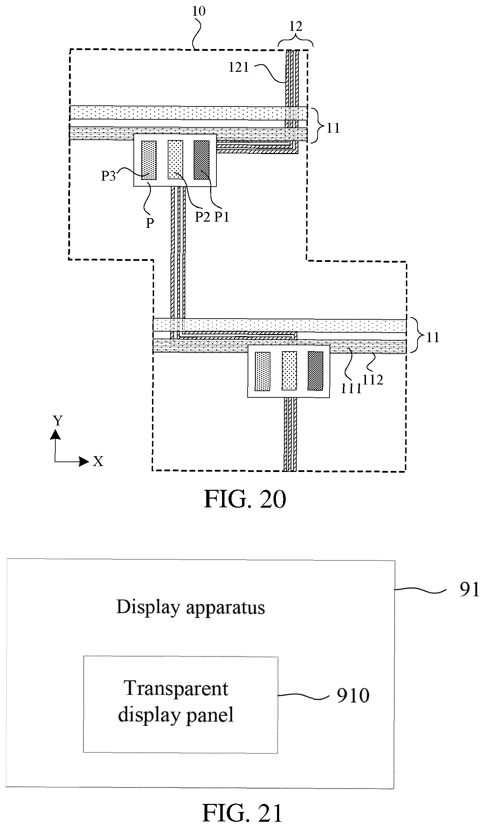

FIG. 19 is another partial schematic view of a transparent display panel according to at least one embodiment of the present disclosure. FIG. 20 is a schematic diagram of a repeating unit of a transparent display panel according to at least one embodiment of the present disclosure. In some examples, as shown in FIG. 19 and FIG. 20, the non-transmissive region of the repeating unit 10 may include: two pixel units P, two sets of first traces 11, and a set of second traces 12. The two pixel units P may be arranged in a second direction Y and may be misaligned in the second direction Y. Each pixel unit P may include a first sub-pixel P1, a second sub-pixel P2, and a third sub-pixel P3 arranged sequentially in a first direction X. Each set of first traces 11 may include a plurality of first signal lines 111 (e.g., they may include: a first scan line, a second scan line, a light emitting control line, and an initial signal line electrically connected to a pixel unit P) extending in the first direction X and a plurality of second signal lines 112 (including, for example, a first power supply line and a second power supply line). The orthographic projection of one of the second signal lines 112 (e.g., the second power supply line) of each set of first traces 11 on the substrate may overlap with the orthographic projection of the plurality of first signal lines 111 on the substrate, and the orthographic projection of another second signal line 112 (e.g., the first power supply line) on the substrate may not overlap with the orthographic projection of the first signal line 111 on the substrate. The set of second traces 12 may include a plurality of third signal lines 121, and the plurality of third signal lines 121 may be a plurality of data lines electrically connected to the two pixel units P. The plurality of third signal lines 121 may be in folding lines in the second direction Y. For example, each third signal line 121 may be formed by sequentially connecting a third line segment extending in the first direction X and a fourth line segment extending in the second direction Y.

This example sets two adjacent pixel units of a same column in a misaligned position, and adopts an aggregation design for the first scan line, the second scan line, the light emitting control line, the first power supply line and the second power supply line of the pixel units of a same row, and a superimposition design for at least one second signal line and a plurality of first signal lines, so that the area of a transmissive region of a minimum unit surrounded by the non-transmissive region can be maximized, thereby reducing diffraction and improving the display quality of the transparent display panel. The rest of the structure of the transparent display panel according to the embodiment may be referred to descriptions of the aforementioned embodiments, and will not be repeated here.

FIG. 21 is a schematic diagram of a display apparatus according to at least one embodiment of the present disclosure. As shown in FIG. 21, this embodiment provides a display apparatus 91, which includes a transparent display panel 910. The transparent display panel 910 may be a micro-LED display panel or a mini-LED display panel. The display apparatus 91 may be: a car window glass, a mall cabinet, an augmented reality (AR, Augmented Reality) device, a virtual reality (VR, Virtual Reality) device, and any other products or components with the transparent display function. However, this embodiment is not limited thereto.

The drawings of the present disclosure only involve structures involved in the present disclosure, and other structures may refer to conventional designs. The embodiments of the present disclosure and features in the embodiments may be combined to each other to obtain new embodiments if there is no conflict. Those of ordinary skills in the art should understand that modifications or equivalent replacements of the technical solutions of the present disclosure may be made without departing from the essence and scope of the technical solutions of the present disclosure, and shall all fall within the scope of the claims of the present disclosure.

## Claims

1. A transparent display panel, comprising:
a substrate,
a plurality of repeating units arranged in an array on said substrate, wherein,
a repeating unit comprises a non-transmissive region and a plurality of transmissive sub-regions, adjacent transmissive sub-regions are spaced apart by a non-transmissive region,
said non-transmissive region comprises at least one pixel unit and N sets of first traces extending in a first direction and M sets of second traces extending in a second direction electrically connected to said at least one pixel unit, said first direction intersects said second direction, both N and M are positive integers, and N and M are not both greater than 1,
at least one set of first traces comprises a plurality of first signal lines and at least one second signal line, an orthographic projection of said at least one second signal line on the substrate covers an orthographic projection of at least two first signal lines on the substrate; or, at least one set of second traces comprises a plurality of third signal lines and at least one fourth signal line, an orthographic projection of said at least one fourth signal line on the substrate covers an orthographic projection of at least two third signal lines on the substrate.

2. The transparent display panel according to claim 1, wherein a size of said at least one second signal line in said second direction is larger than a size of said at least two first signal lines in said second direction.

3. The transparent display panel according to claim 1 or 2, wherein said at least one second signal line is located on a side of said at least two first signal lines away from said substrate.

4. The transparent display panel according to claim 1, wherein a size of said at least one fourth signal line in said first direction is larger than a size of said at least two third signal lines in said first direction.

5. The transparent display panel according to claim 1 or 4, wherein said at least one fourth signal line is located on a side of said at least two third signal lines away from said substrate.

6. The transparent display panel according to any one of claims 1 to 5, wherein said at least one second signal line or said at least one fourth signal line is a power supply line.

7. The transparent display panel according to any one of claims 1 to 6, wherein both N and M are 1.

8. The transparent display panel according to claim 7, wherein a set of first traces comprise a plurality of first signal lines, and a set of second traces comprise a plurality of third signal lines and at least one fourth signal line;
said at least one fourth signal line comprises a first power supply line and a second power supply line, and
an orthographic projection of at least one of said first power supply line and said second power supply line on said substrate covers an orthographic projection of said plurality of third signal lines on said substrate.

9. The transparent display panel according to claim 8, wherein said plurality of first signal lines of said set of first traces comprise a scan line, a light emitting control line, a first power connection line, and a second power connection line, said first power connection line is electrically connected to said first power supply line, and said second power connection line is electrically connected to said second power supply line.

10. The transparent display panel according to claim 8, further comprising a shift-scan circuit, wherein
an orthographic projection of said at least one fourth signal line on said substrate overlaps with said shift-scan circuit.

11. The transparent display panel according to claim 10, wherein said non-transmissive region of said repeating unit comprises three pixel units arranged sequentially in said first direction, said set of second traces are adjacent to a second pixel unit.

12. The transparent display panel according to claim 7, wherein
a set of first traces comprise a plurality of first signal lines and at least one second signal line;
a set of second traces comprise a plurality of third signal lines;
said at least one second signal line comprises a first power supply line and a second power supply line, and
an orthographic projection of at least one of said first power supply line and said second power supply line on said substrate covers an orthographic projection of at least two first signal lines on said substrate.

13. The transparent display panel according to claim 12, wherein said plurality of first signal lines comprise at least one scan line and at least one light emitting control line that are electrically connected to said at least one pixel unit.

14. The transparent display panel according to any one of claims 8 to 13, wherein said plurality of third signal lines comprises at least a plurality of data lines electrically connected to said at least one pixel unit.

15. The transparent display panel according to any one of claims 8 to 14, wherein an orthographic projection of said second power supply line on said substrate overlaps with an orthographic projection of said at least one pixel unit on said substrate, and
said first power supply line is located on a side of said second power supply line away from said pixel unit.

16. The transparent display panel according to any one of claims 8 to 15, wherein
said at least one pixel unit comprises a plurality of sub-pixels emitting different colors, each sub-pixel comprises a light emitting element and a pixel circuit electrically connected to said light emitting element, a first electrode of said light emitting element is electrically connected to said pixel circuit via an anode pad, a second electrode of said light emitting element is electrically connected to a cathode pad, and said cathode pad and said second power supply line are an integrated structure.

17. The transparent display panel according to any one of claims 8 to 16, wherein a first voltage signal provided by said first power supply line is greater than a second voltage signal provided by said second power supply line.

18. The transparent display panel according to any one of claims 1 to 17, wherein said repeating unit is a quadrilateral.

19. The transparent display panel according to any one of claims 1 to 6, wherein said non-transmissive region comprises two pixel units, a set of first traces and two sets of second traces, and said two pixel units are arranged in said first direction and are misaligned.

20. The transparent display panel according to claim 19, wherein
a set of first traces comprise a plurality of first signal lines,
a first signal line comprises a first line segment extending in said first direction and a second line segment extending in said second direction that are connected sequentially,
each of two sets of second traces comprises a plurality of third traces and at least one fourth trace,
an orthographic projection of said at least one fourth trace on said substrate overlaps with an orthographic projection of second line segments of said plurality of first signal lines on said substrate.

21. The transparent display panel according to any one of claims 1 to 20, wherein
said at least one pixel unit comprises a plurality of sub-pixels emitting different colors,
each sub-pixel comprises a light emitting element and a pixel circuit electrically connected to said light emitting element, and
an orthographic projection of the light emitting element of said sub-pixel on said substrate overlaps with an orthographic projection of the electrically connected pixel circuit on said substrate.

22. A display apparatus, comprising the transparent display panel according to any one of claims 1 to 21.
